# EUROPÄISCHE PATENTSCHRIFT

(11) **EP 2 172 752 B1**
(45) Veröffentlichungstag und Bekanntmachung des Hinweises auf die Patenterteilung: **04.06.2014**
(21) Anmeldenummer: 09170409.8
(22) Anmeldetag: 16.09.2009
(51) Int. Cl.: G01N 31/22, G01J 1/50, G01K 3/04, G01T 1/04, G03C 1/685, G03F 7/105, G03C 1/73

(54) **Verwendung eines Mehrbereichsindikators für die Bestimmung der Dosis von UV-Strahlung in mindestens zwei Strahlungswellenlängenbereichen und Verfahren zur Bestimmung der Dosis von UV-Strahlung**
Use of a multiple range indicator for determining the dose of UV-radiation in at least two wavelength-ranges and method for the determination of a dose of UV radiation
Utilisation d'un indicateur à plusieurs domaines pour déterminer la dose d'une radiation UV dans au moins deux gammes de longueur d'ondes et méthode pour la détermination d'une dose de raditiation UV

(30) Priorität: 01.10.2008 DE 102008049848
(43) Veröffentlichungstag der Anmeldung: 07.04.2010
(73) Patentinhaber: tesa SE, 20253 Hamburg (DE)
(72) Erfinder: Keite-Telgenbüscher, Klaus, 22529 Hamburg (DE); Neuhaus-Steinmetz, Hermann, 22926 Ahrensburg (DE)

(56) Entgegenhaltungen:
- WO-A1-2008/022952
- WO-A1-2009/103611
- GB-A- 2 430 257
- US-A- 2 936 276
- US-A- 4 507 226

## Beschreibung

Die Erfindung betrifft die Verwendung eines Mehrbereichsindikators wie sie in Anspruch 1 definiert wird, sowie ein Verfahren zum Bestimmen einer auf einen Probenkörper eingestrahlten Dosis elektromagnetischer Strahlung. Der Mehrbereichsindikator selbst ist nicht Teil der Erfindung.

Bei einer chemischen Reaktion treten strukturelle Änderungen an einem oder mehreren Reaktanden auf. So wird in einer photochemischen Reaktion infolge der Wechselwirkung eines Agens (eines der Reaktanden) mit elektromagnetischer Strahlung die molekulare Beschaffenheit des Agens verändert, sofern die elektromagnetische Strahlung hinsichtlich ihrer Wellenlänge und Intensität derart gewählt ist, dass die Strahlung von dem Agens absorbiert wird.

Da die Einwirkung der Strahlung bei einer photochemischen Reaktion eine "Aktion" zur Folge hat, wird elektromagnetische Strahlung mit einer Wellenlänge, bei der eine Reaktion initiiert wird, auch als "aktinische Strahlung" bezeichnet. Bei aktinischer Strahlung handelt es sich also etwa um energiereiches Licht, beispielsweise um Strahlung aus dem ultravioletten Bereich des Spektrums (UV-Strahlung, UV-Licht) oder um blaues Licht (aktinisches Licht). Andere Formen aktinischer Strahlung stellen beispielsweise Gammastrahlung oder Elektronenstrahlen dar, etwa Kanalstrahlen.

Die Wellenlängen der Strahlung im ultravioletten Bereich werden nach DIN 5031, Teil 7 in drei Teilbereiche unterteilt, nämlich in die Bereiche UVA, UVB und UVC. Die ultraviolette Strahlung aus dem UVA-Bereich weist Wellenlängen von 380 nm bis 315 nm auf (das so genannte "Schwarzlicht") und entspricht damit niederenergetischer UV-Strahlung. Die ultraviolette Strahlung aus dem UVB-Bereich weist Wellenlängen von 315 nm bis 280 nm auf, wohingegen die ultraviolette Strahlung aus dem UVC-Bereich mit Wellenlängen von 280 nm bis 100 nm die höchste Energie besitzt. Neben diesem Klassifikationsschema sind in der Praxis auch andere Unterteilungen üblich, etwa die in nahes UV (NUV; Wellenlänge: 400 nm-200 nm), fernes UV (auch als "Vakuum-UV" bezeichnet; FUV, VUV; Wellenlänge: 200 nm-10 nm) und extremes UV (EUV, XUV; Wellenlänge: 31 nm-1 nm).

Strahlung mit einer Wellenlänge, bei der das Agens keine Absorption zeigt, kann nicht mit dem Agens in Wechselwirkung treten und somit keine photochemische Reaktion zur Folge haben. Damit eine photochemische Reaktion überhaupt stattfinden kann, muss die Wellenlänge der verwendeten aktinischen Strahlung daher zumindest teilweise mit der spektralen Absorption des Agens übereinstimmen. So weisen molekulare Reaktanden üblicherweise Absorptionsbanden auf, die in spektraler Hinsicht recht schmal sind, so dass es zumeist schwierig ist, Strahlungsquellen mit einer Emissionscharakteristik zu finden, die speziell auf die Absorption eines solchen Reaktanden abgestimmt ist. Daher werden für photochemische Reaktionen häufig aktinische Strahlungsquellen eingesetzt, die in einem breiten Spektralbereich aktinische Strahlung emittieren, von der dann nur ein geringer Teil von dem Agens absorbiert wird.

Der Umsatz einer photochemischen Reaktion kann unter anderem von der Anzahl insgesamt eingestrahlter Photonen mit der richtigen Energie und somit von der Strahlungsdosis der aktinischen Strahlung abhängen. Die Strahlungsdosis wiederum skaliert mit der Bestrahlungsintensität und der Bestrahlungsdauer. Zur Überwachung des tatsächlich erreichten Reaktionsumsatzes ist es daher erforderlich, den Ablauf einer photochemischen Reaktion eines Agens *in situ* zu überwachen, etwa beim Aushärten eines Polymersystems unter Bestrahlung mit UV-Licht. Da nur ein Teil der emittierten aktinischen Strahlung eine Wellenlänge aufweist, die von dem Agens absorbiert wird, ist es für die exakte Überwachung der eingestrahlten Dosis zusätzlich wünschenswert, wenn die Bestimmung der aktinischen Strahlung so durchgeführt wird, dass die unterschiedlichen Wellenlängenbereiche separat detektiert werden, um so die tatsächliche relevante Energiedosis ermitteln zu können.

Hinzu kommt, dass herkömmliche Einrichtungen zur Erzeugung aktinischer Strahlung ihre Gesamtleistung sowie ihre spektrale Intensitätsverteilung während ihres Betriebs ändern können. So verlieren zum Beispiel industrieübliche elektrisch betriebene UV-Strahlungsquellen während der ersten tausend Betriebstunden etwa ein Fünftel ihrer anfänglichen Intensität und sind zudem äußerst empfindlich gegenüber Verschmutzungen. Zu der verlässlichen Überwachung einer industriell genutzten photochemischen Reaktion ist es daher zwingend erforderlich, dass die Detektion der aktinischen Strahlung zumindest teilweise spektral aufgelöst erfolgt, um zeitliche Änderungen in der Bestrahlungsintensität zu erfassen und damit eine Ursachenanalyse bei Schwankungen der Produktqualität zu vereinfachen.

Zu diesem Zweck existieren elektronische Dosismessgeräte, die eine bereichsweise differenzierbare Dosisbestimmung des einfallenden UV-Lichts erlauben. So lassen sich beispielsweise mit dem elektronisch arbeitenden UV-Dosismessgerät "Power Puck" der Firma EIT (USA) Dosismessungen in vier unterschiedlichen Wellenlängenbereichen durchführen, nämlich in den Bereichen von 250 nm bis 260 nm, von 280 nm bis 320 nm, von 320 nm bis 390 nm und von 395 nm bis 445 nm.

Elektronische Dosismessgeräte besitzen jedoch den Nachteil, dass deren Abmessungen relativ groß sind. So weist das Dosismessgerät "Power Puck" einen Durchmesser von etwa 100 mm und eine Höhe von etwa 15 mm auf. Aufgrund ihrer Abmessungen sind derartige Geräte häufig für die Überwachung der Strahlungsexposition von Produkten innerhalb geschlossener Fertigungsstraßen und Verarbeitungsanlagen ungeeignet.

Soll zum Beispiel eine Vernetzungsreaktion von bahnförmigen Polymerschichten überwacht werden, die unter Einwirkung ultravioletter Strahlung stattfindet (bei so genannten "strahlenvernetzenden Polymersystemen"), so ist ein Einsatz elektronischer Dosismessgeräte nicht möglich, da das bahnförmige Material an UV-Lampen vorbei geführt wird, die in der Regel in unmittelbarer Nähe von Umlenkwalzen angeordnet sind (also direkt davor/dahinter oder darüber/darunter), so dass dort für die Positionierung des Dosismessgeräts auf dem bahnförmigen Material nicht genügend Platz ist.

Zudem wird infolge der Höhe elektronischer Dosismessgeräte die Strahlungsdosis nicht direkt am Ort des bahnförmigen Materials erfasst, sondern ein kleines Stück oberhalb dieser Stelle (bei "Power Puck" etwa 15 mm darüber). Daher geben die erhaltenen Messwerte auch nicht die tatsächliche Strahlungsdosis in der Bestrahlungsebene wieder, sondern sind vielmehr verfälscht, was insbesondere bei einem schrägen Strahlungseinfall zu erheblichen Abweichungen gegenüber der tatsächlichen Strahlungsdosis am Ort des Produkts aufgrund der Messaufnehmergeometrie führen kann.

Noch problematischer ist die Situation, wenn die UV-Strahlungsdosis nicht für bahnförmige Materialien sondern für dreidimensionale Formteile bestimmt werden soll, etwa um eine homogene Vernetzung strahlenvernetzter Formteile zu gewährleisten. In diesem Fall ist für die korrekte Erfassung eine Bestimmung der Strahlungsdosis exakt am Ort der jeweiligen Oberflächenbereiche der Formteile erforderlich, was mit einem elektronischen Dosismessgerät praktisch nicht realisierbar ist.

Bei der Prozessüberwachung photochemisch reagierender Systeme besteht demzufolge häufig keine Möglichkeit, die tatsächliche Strahlungsdosis mittels elektronischer Dosismessgeräte verlässlich zu bestimmen, so dass stattdessen eine aufwändige Qualitätssicherung durch Überwachung einer Vielzahl unterschiedlicher Produktmerkmale zu betreiben ist.

Alternativ zu einer elektronischen Messung kann die Strahlungsdosisbestimmung auch chemisch erfolgen, indem dem Agens eine Indikatorsubstanz hinzugefügt wird, die den jeweiligen Umsatz optisch detektierbar anzeigt. Als Indikator wird üblicherweise ein System verwendet, in dem unter Einwirkung des jeweiligen aktinischen Lichts eine weitere photochemische Reaktion abläuft, die eine Absorptionsänderung des Indikators zur Folge hat. Anhand des Grads der Verfärbung ist es möglich, die jeweilige Strahlungsdosis qualitativ und gegebenenfalls auch quantitativ zu verfolgen, so dass der tatsächliche Umsatz des Agens ermittelt werden kann. Die Überwachung kann dabei visuell oder apparativ erfolgen.

Indikatorsysteme, bei denen infolge Einwirkung aktinischer Strahlung eine Farbänderung eintritt (so genannte "radiochrome Farbumschlagsysteme"), werden beispielsweise zur Messung der eingestrahlten Dosis aktinischer Strahlung oder zur Kennzeichnung belichteter Bereiche auf Substraten eingesetzt, beispielsweise bei der Belichtung von Photolackplatten (Fotoresist-Platten).

Aus dem Stand der Technik sind eine Vielzahl an flüssigen oder festen Systemen bekannt, die eine Einwirkung aktinischer Strahlung visuell erkennen lassen. So sind etwa in US 4,923,781 photopolymerisierbare bilderzeugende Systeme und in EP 0 291 880 B1 photopolymerisierbare Aufzeichnungsmaterialien beschrieben, wohingegen aus US 5,677,107 photochemisch vermittelte dreidimensionale Formgebungsverfahren bekannt sind.

Anwendungsspezifische Dosismesssysteme (so genannte "Dosimeter") auf der Basis photochemischer Reaktionen sind unter anderem Gegenstand von US 4,130,760, US 3,787,687 und DE 197 19 721 C1. Die in diesen Dokumenten vorgestellten Systeme weisen jeweils einen Indikatorfarbstoff auf, der die aktinische Strahlung absorbiert und infolge der dabei aufgenommenen Energie unter Veränderung seiner Absorption reagiert, so dass die aufgenommene Dosis anschließend durch Farbvergleich bestimmbar ist, gegebenenfalls nach einem weiteren Schritt zur Entwicklung des detektierbaren Farbstoffs.

Es sind allerdings nur wenige Verbindungen bekannt, die gleichzeitig eine Absorption im Wellenlängenbereich der nachzuweisenden aktinischen Strahlung (Nachweiswellenlänge oder Detektionswellenlänge) und eine photochemisch beeinflussbare Absorption im Wellenlängenbereich des sichtbaren Lichts (Beobachtungswellenlänge, Anzeigewellenlänge oder Indikationswellenlänge) zur visuellen Anzeige der absorbierten Dosis besitzen. Die Anzahl an direkt reagierenden Indikatorsystemen ist daher relativ gering, weshalb nur wenige Wellenlängenbereiche einem direkten Nachweis der aktinischen Strahlung zugänglich sind.

Demgegenüber bieten indirekt reagierende Indikatorsysteme den Vorteil, dass diese gezielt anpassbar sind und dadurch einem Nachweis aktinischer Strahlung aus unterschiedlichen Wellenlängenbereichen dienen können. Ein indirekt reagierendes Indikatorsystem ist ein Indikatorsystem, das eine photochemisch aktive Substanz und zusätzlich einen Indikatorfarbstoff enthält. Bei Bestrahlung mit aktinischer Strahlung wird die einfallende Strahlung von der photochemisch aktiven Substanz absorbiert. Infolge der dabei aufgenommenen Energie findet eine Reaktion der photochemisch aktiven Substanz statt. Die bei der Reaktion entstehenden Mittleragentien (ggf.

Zwischenprodukte) reagieren wiederum mit dem Indikatorfarbstoff, wobei sich dessen Absorption im sichtbaren Bereich des Lichtspektrums ändert. Zwar kann es bei einer solchen indirekten Reaktion vorkommen, dass dabei zusätzlich auch eine Absorptionsänderung der photochemisch aktiven Substanz im sichtbaren Bereich des Spektrums eintritt, jedoch ist das etwaige Auftreten eines derartigen Effekts üblicherweise unerheblich.

Dadurch, dass bei den indirekt reagierenden Systemen die Substanzen, die im Wellenlängenbereich der nachzuweisenden aktinischen Strahlung absorbieren, und die Substanzen, deren Absorption im Wellenlängenbereich des sichtbaren Lichts sich ändert, unterschiedlich gewählt werden können, sind die Nachweiswellenlänge und die Anzeigewellenlänge voneinander entkoppelt, so dass die photochemisch aktive Substanz und der Indikatorfarbstoff leicht den jeweiligen Untersuchungsbedingungen entsprechend ausgewählt und in breitem Rahmen angepasst werden können.

Seit kurzem sind einige Beispiele für indirekt reagierende Indikatorsysteme bekannt, die als photochemisch aktive Substanz eine photolatente Säure (einen Säurebildner) enthalten. Diese photolatente Säure liegt im unbestrahlten Zustand nicht als Säure vor, sondern es wird erst bei einer Bestrahlung mit aktinischer Strahlung hieraus eine Säure freigesetzt. Die freigesetzte Säure reagiert mit einem im neutralen Bereich farblosen Indikatorfarbstoff, der als Farbbildner (latenter Farbstoff; Farbstoff-Vorstufe; beispielsweise ein Leukofarbstoff) eingesetzt wird und der infolge der chemischen Reaktion mit der freigesetzten Säure seine Absorption im sichtbaren Bereich des Lichtspektrums ändert. Für die Intensität der Farbveränderung kommt es dabei auf die Menge der photochemisch aus der photolatenten Säure freigesetzten Säure an. In WO 2005/097876 A1 sind unterschiedliche photolatente Säuren, Indikatorfarbstoffe und Matrixsysteme zur Aufnahme der photolatenten Säure und des Indikatorfarbstoffs beschrieben.

Der Wellenlängenbereich (die Nachweiswellenlängen), innerhalb dessen ein solches System als Indikator eingesetzt werden kann, hängt im Wesentlichen von der Absorption der photolatenten Säure des Indikatorsystems im Wellenlängenbereich der aktinischen Strahlung ab. Als photolatente Säure sind eine Vielzahl unterschiedlicher latenter Säuren einsetzbar, die bei Einwirkung aktinischer Strahlung jeweils in eine Säure umgewandelt werden und die sich hinsichtlich ihrer Absorption im Wellenlängenbereich der aktinischen Strahlung zum Teil stark unterscheiden.

Demzufolge enthält dieses indirekt reagierende Indikatorsystem also eine nachweiswellenlängenspezifische photolatente Säure und einen nachweiswellenlängenunspezifischen Indikatorfarbstoff (der jedoch anzeigewellenlängenspezifisch ist) sowie - intermediär- als Mittleragens eine Säure, die photochemisch aus der photolatenten Säure freigesetzt wird und mit dem Indikatorfarbstoff unter Farbveränderung des Indikatorfarbstoffs reagiert. Durch die Wahl einer photolatenten Säure mit einem geeigneten Absorptionsspektrum werden Indikatorsysteme erhalten, mittels derer aktinische Strahlung aus nahezu jedem Wellenlängenbereich spezifisch nachgewiesen werden kann.

An diesen indirekt reagierenden Indikatorsystemen ist jedoch nachteilig, dass der damit erzielte Farbumschlag nicht permanent beibehalten wird und die Verfärbung somit nicht stabil ist, sondern dass sich deren Färbung unter Einwirkung von Licht, Feuchtigkeit und/oder Wärme vielmehr innerhalb von kurzer Zeit verändert.

Weiterhin ist es ungünstig, dass die Intensität des mit diesen Systemen erzielten Farbumschlags im Allgemeinen mit der insgesamt eingestrahlten Dosis keine feste mathematische Relation bildet, so dass eine quantitative Bestimmung der eingestrahlten Dosis allenfalls - wenn überhaupt - nach einer umfangreichen und somit aufwändigen Kalibrierung möglich ist.

Darüber hinaus haben sich diese Systeme als unpraktisch herausgestellt, da sie häufig nicht ausschließlich mit aktinischer Strahlung sondern auch mit Licht anderer Wellenlängen wie etwa sichtbarem Licht photochemisch reagieren können, so dass sie im unbestrahlten Zustand in der Regel eine schlechte Lagerstabilität aufweisen und zudem eine umständliche Handhabung erfordern.

Es besteht daher ein grundsätzlicher Bedarf an Indikatoren, die zuverlässige Dosisbestimmungen in jeweils unterschiedlichen Wellenlängenbereichen ermöglichen, wozu farbstabile Farbänderungen und mit der eingestrahlten Dosis definiert skalierende Intensitäten der Farbumschläge erforderlich sind.

Einer der Vorteile der indirekt reagierenden Indikatorsysteme besteht in der großen Anzahl an verfügbaren photolatenten Säuren mit Absorptionen bei unterschiedlichen Wellenlängen, mittels derer ein breiter Nachweiswellenlängenbereich abgedeckt werden kann. So ist es gemäß WO 2005/097876 A1 sogar möglich, ein Indikatorsystem mit mehreren photolatenten Säuren herzustellen, deren Absorptionsspektren einander überlappen, so dass aktinische Strahlung in einem großen Wellenlängenbereich detektiert werden kann. Die aus den verschiedenen photolatenten Säuren freigesetzten Säuren reagieren mit dem Farbstoff jedoch auf identische Weise in derselben Farbreaktion und somit unspezifisch. Daher kann mittels solcher Indikatorsysteme die aktinische Strahlung lediglich integral detektiert werden, ohne dass es möglich ist, zwischen einzelnen Wellenlängenbereichen zu unterscheiden.

Demzufolge wäre es bei Verwendung des aus dem Stand der Technik bekannten Indikatorsystems zwar möglich, die insgesamt eingestrahlte Dosis polychromatischer aktinischer Strahlung zu detektieren, jedoch würde dabei nicht zwischen niederenergetischer UVA-Strahlung und hochenergetischer UVC-Strahlung differenziert. Eine nachweiswellenlängenselektive Detektion wäre mit solchen indirekt reagierenden Indikatoren allenfalls dann realisierbar, wenn zwei in unterschiedlichen Wellenlängenbereichen absorbierende und zudem räumlich voneinander getrennte Indikatorsysteme verwendet würden. Wie obenstehend dargestellt ist jedoch grade eine derartige nachweiswellenlängenselektive Detektion unabdingbar, wenn die Funktionalität herkömmlicher elektronischer Dosismessgeräte mit chemischen Indikatoren erreicht werden soll.

Somit besteht also ein Bedarf an einem Mehrbereichsindikator, der insbesondere die Dosis von aktinischer Strahlung mit Wellenlängen aus unterschiedlichen Wellenlängenbereichen jeweils parallel detektierbar wiedergibt, so dass innerhalb einer einzigen Bestimmung zwischen zumindest zwei Wellenlängenbereichen mit hinreichender Messgenauigkeit unterschieden werden kann.

Ein allgemeines Konzept zur Herstellung von Mehrbereichsindikatoren kann grundsätzlich darin bestehen, mehrere Indikatorsysteme in einem einzigen Indikator einzusetzen. Bei der praktischen Umsetzung dieses allgemeinen Konzepts gestaltet es sich jedoch als äußerst schwierig, geeignete Indikatorsysteme für die unterschiedlichen Nachweiswellenlängen zu finden, die sich nicht gegenseitig beeinflussen.

Dies ist insbesondere bei einem Mehrbereichsindikator mit mehreren Indikatorsystemen problematisch, von denen eines auf der Verwendung von photolatenten Säuren oder Basen beruht (oder - noch allgemeiner - auf der Verwendung photolatenter Lewissäuren oder -basen), die mit einem Indikatorfarbstoff reagieren und so eine Farbänderung hervorrufen, da nahezu alle organischen Indikatorfarbstoffe chemische Gruppen enthalten, die mit den intermediär erzeugten Säuren oder Basen in Wechselwirkung treten können.

In den meisten Fällen ist die - zumeist unspezifische - Wechselwirkung der intermediär erzeugten Lewissäuren oder -basen mit den Indikatorfarbstoffen auf die Eignung der Lewissäuren bzw. -basen zurückzuführen, als Elektronenpaarakzeptoren bzw. Elektronenpaardonatoren zu wirken. So können Lewissäuren beispielsweise mit Gruppen an organischen Farbstoffmolekülen in Wechselwirkung treten, etwa Gruppen mit Sauerstoff- oder Stickstoffatomen, beispielsweise mit Ether-, Hydroxyl-, Carbonyl- oder Aminogruppen, wobei es zur Ausbildung von Lewisaddukten kommen kann (Lewissäure-Lewisbase-Reaktion).

Tritt die Lewissäure oder -base eines ersten Indikatorsystems mit dem Indikatorfarbstoff eines anderen Indikatorsystems in Wechselwirkung, kann jedoch nicht die gesamte Menge der erzeugten Lewissäuren zu einer Farbänderung des ersten Indikatorsystems beitragen. Demzufolge fällt das Ergebnis einer quantitativen Dosisbestimmung mittels des ersten Indikatorsystems niedriger aus als es der tatsächlich eingestrahlten Dosis entspräche.

Noch problematischer ist es, wenn die Reaktion des Indikatorfarbstoff des zweiten Indikatorsystems mit der Lewissäure oder -base ebenfalls in diesem Indikatorsystem eine Farbänderung zur Folge hat, da hierdurch die quantitative Bestimmung beider Indikatorsysteme verfälscht wird, indem die des ersten Indikatorsystems einen zu niedrigen Wert ergibt, die des zweiten Indikatorsystems hingegen infolge des zusätzlichen Beitrags einen zu hohen Wert.

Dabei ist es nicht einmal möglich, die gegenseitige Verfälschung nachträglich zu korrigieren, da dies allenfalls dann erfolgen könnte, wenn die absoluten Intensitäten der Nachweisstrahlung für beide Wellenlängenbereiche bekannt wären; diese sollen jedoch grade mit Hilfe des Mehrbereichsindikators ermittelt werden. Hinzu kommt, dass die molaren Extinktionskoeffizienten der Farbstoffe unterschiedlich groß sind, so dass eine Absorptionsänderung bei der Anzeigewellenlänge des einen Indikatorfarbstoffs nicht ohne weiteres in eine Konzentrationsänderung des anderen Indikatorfarbstoffs umgedeutet werden kann.

Demzufolge bestand die spezielle Aufgabe der vorliegenden Erfindung darin, ein Verfahren für eine gleichzeitige Dosisbestimmung von UVA, UVB und/oder UVC Strahlung bereitzustellen, wobei ein Mehrbereichsindikator mit einem Indikatorsystem auf der Basis eines ersten Indikatorfarbstoffs und einer photolatenten Lewissäure oder -base verwendet wird, und bei dem zusätzlich ein zweites Indikatorsystem vorgesehen ist, das eine derart geringe Wechselwirkung mit dem ersten Indikatorsystem aufweist, so dass bei den unterschiedlichen Nachweiswellenlängen quantitative Dosisbestimmungen parallel durchführbar sind. Im Hinblick auf die Zuverlässigkeit der Dosisbestimmung ist dabei jeweils eine farbstabile Farbänderung sowie eine mit der eingestrahlten Dosis skalierende Intensität des Farbumschlags für die unterschiedlichen Wellenlängenbereiche erforderlich.

Diese Aufgabe wird erfindungsgemäß durch die Verwendung eines Mehrbereichsindikator der eingangs genannten Art gelöst, bei dem zusätzlich zu dem ersten Indikatorsystem ein zweites Indikatorsystem vorhanden ist, das einen zweiten Indikatorfarbstoff umfasst und das zu einer Änderung der Lichtabsorption des zweiten Indikatorfarbstoffs in einer zweiten Reaktion bei Einwirkung von elektromagnetischer Strahlung mit Wellenlängen aus einem zweiten Strahlungswellenlängenbereich in der Lage ist, wobei der zweite Indikatorfarbstoff ein Triphenylmethanfarbstoff ist, in dem das zentrale C-Atom der Methangruppe mit einer Struktureinheit ausgewählt aus der Gruppe umfassend Halogene, Pseudohalogene, Chalkogene, Sulfate und substituierte oder unsubstituierte Tosylate verbunden ist, und in dem zumindest einer der C₆-Ringe der Phenylgruppen in ortho- oder para-Stellung zu der Bindung zu dem zentralen Methyl-C-Atom einen elektronenziehenden Substituenten mit einem +M-Effekt und/oder in meta-Stellung zu der Bindung zu dem zentralen Methyl-C-Atom einen elektronenschiebenden Substituenten mit einem +M-Effekt aufweist.

Der Einsatz zweier photochromer Farbumschlagssysteme, deren spektrale Empfindlichkeitsbereiche (Absorption) einander zumindest nicht vollständig überlappen, für eine gleichzeitige Dosisbestimmung in mindestens zwei unterschiedlichen Wellenlängenbereichen ist grundsätzlich realisierbar. Jedoch lediglich dadurch, dass die Strahlungswellenlängenbereiche der ersten Reaktion und der zweiten Reaktion unterschiedlich sind, wird es möglich, die Dosis der aktinischen Strahlung für zwei verschiedene Wellenlängebereiche zu bestimmen. Darüber hinaus erlaubt erst der Einsatz zweier Indikatorsysteme, die im Hinblick auf den Mechanismus der Farbänderungsreaktion der Indikatorfarbstoffe unterschiedlich sind, die Dosisbestimmung für die beiden unterschiedlichen Wellenlängebereiche voneinander unabhängig parallel nebeneinander durchzuführen.

Überraschenderweise und für den Fachmann nicht vorhersehbar hat sich herausgestellt, dass wenn zusätzlich zu einem Indikatorsystem mit einem ersten Indikatorfarbstoff und einer photolatenten Lewissäure oder -base ein zweites Indikatorsystem eingesetzt wird, das als Indikatorfarbstoff eine Verbindung aus der zuvor beschriebenen besonderen Klasse von Farbstoffen enthält, der resultierende Mehrbereichsindikator eine zuverlässige parallele Bestimmung der Strahlungsdosen in unterschiedlichen Wellenlängenbereichen erlaubt, ohne dass die darin enthaltenen Indikatorsysteme die Bestimmungsergebnisse verfälschen, sondern vielmehr unabhängig voneinander eine exakte Bestimmung der eingestrahlten Dosis zulassen.

Dies ist um so erstaunlicher, als bei Indikatorfarbstoffen, die Struktureinheiten mit nichtbindenden Elektronenpaaren (also etwa Halogene, Pseudohalogene, Chalkogene, Sulfate und Tosylate wie auch andere Substituenten mit einem +M-Effekt) enthalten und darüber hinaus auch noch elektronenziehende oder elektronenschiebende Substituenten mit zusätzlichen Elektronenpaaren aufweisen, eine besonders große Wechselwirkung insbesondere mit Lewissäuren auftreten sollte, so dass demzufolge auch eine starke Verfälschung der Bestimmungsergebnisse zu erwarten wäre, was vorliegend jedoch nicht beobachtet wurde.

Als vorteilhaft hat es sich dabei herausgestellt, den Mehrbereichsindikator als UV-Mehrbereichsindikator auszubilden und derart anzupassen, dass die von dem ersten Indikatorsystem absorbierte elektromagnetische Strahlung und die von dem zweiten Indikatorsystem absorbierte elektromagnetische Strahlung jeweils Licht aus dem ultravioletten Bereich des Spektrums ist. Auf diese Weise wird ein Mehrbereichsindikator erhalten, der für diejenige Art aktinischer Strahlung besonders geeignet ist, die am häufigsten in der Photoreaktionstechnik eingesetzt wird.

Insbesondere ist es dabei günstig, wenn das eine Indikatorsystem zur Absorption von Licht aus dem UVA-Bereich des Spektrums und das andere Indikatorsystem zur Absorption von Licht aus dem UVB- und/oder dem UVC-Bereich des Spektrums des Spektrums in der Lage ist, beispielsweise, indem das erste Indikatorsystem zur Absorption von UVA-Strahlung und das zweite Indikatorsystem zur Absorption von UVB-und/oder UVC-Strahlung in der Lage ist. Auf diese Weise ist die höherenergetische UVB-und UVC-Strahlung, die im Emissionsspektrum üblicher UV-Strahlungsquellen in nur geringer Intensität anfällt, unabhängig von der niederenergetischen UVA-Strahlung detektierbar, der im Emissionsspektrum üblicher UV-Strahlungsquellen eine höhere Intensität zukommt. Dadurch ist es möglich, die Konzentrationen der Indikatorsysteme jeweils derart zu wählen, dass der Mehrbereichsindikator in beiden Wellenlängenbereichen eine dem Emissionsspektrum der UV-Strahlungsquelle angepasste Empfindlichkeit aufweist, um so eine optimale Ausnutzung der Messbereiche zu erlauben und somit eine verbesserte Empfindlichkeit zu bieten. Dieser Effekt kann durch die Verwendung von inerten absorbierenden Filtermaterialien zur gezielten Abschwächung des UV-Lichts aus den unterschiedlichen Wellenlängenbereichen zusätzlich verbessert werden, die beispielsweise innerhalb des Mehrbereichsindikators oder als separate Filterfolie angeordnet sein können.

Es hat sich ferner als günstig herausgestellt, wenn der erste Indikatorfarbstoff und/oder der zweite Indikatorfarbstoff vor der Einwirkung der elektromagnetischen Strahlung (im Lagerungszustand) als Leukofarbstoffe vorliegen, da auf diese Weise eine besonders gut detektierbare Farbänderungsreaktion mit einem maximalen Helligkeitskontrast gewährleistet ist, der qualitativ auch mit dem bloßen Auge gut wahrgenommen werden kann, nämlich eine Farbänderung von dem farblosen Zustand in einen gefärbten Zustand.

Im Hinblick auf das erste Indikatorsystem ist es günstig, wenn dessen photolatente Lewissäure zumindest eine photolatente Brønstedsäure und dessen erster Indikatorfarbstoff zumindest einen Brønstedsäure-empfindlichen Farbstoff umfasst. Auf diese Weise kann die Farbänderungsreaktion schnell ablaufen und somit die Gesamtdosis nahezu ohne Latenz bestimmt werden. Gleichzeitig ist es möglich, die daran beteiligte photolatente Lewissäure aus einer großen Vielzahl bekannter latenter Säuren auszuwählen und dadurch den Bereich der Nachweiswellenlänge für das erste Indikatorsystem hinsichtlich seiner spektralen Lage und Breite nahezu beliebig zu wählen. Bei der Verwendung eines derartigen ersten Indikatorsystems wird zudem eine besonders geringe Interaktion mit dem erfindungsgemäß einzusetzenden zweiten Indikatorsystem erhalten.

Insbesondere ist die Verwendung eines Fluorans als säureempfindlicher Farbstoff vorteilhaft, da sich auf diese Weise ein zügig eintretender Farbumschlag realisieren lässt, der sich über einen großen Dosisbereich definiert und somit berechenbar mit der eingestrahlten Dosis ändert und zudem eine besonders hohe Farbstabilität sowie Temperaturbeständigkeit aufweist.

Für das zweite Indikatorsystem ist es hingegen sinnvoll, wenn dessen zweiter Indikatorfarbstoff ein Triphenylmethanfarbstoff ist, dessen mit dem zentralen C-Atom der Methangruppe verbundene Struktureinheit eine Cyanogruppe ist. Infolge dieser Ausbildung kann die Farbänderung durch eine heterolytische Abspaltung der Nitrilgruppe als Cyanid-Anion bewirkt werden, die zügig abläuft, und das entstehende Cyanid-Anion aus dem Gleichgewicht entfernt werden, etwa durch Komplexbildung mit in dem Indikator vorhandenen Übergangsmetallaktionen, so dass die Farbänderung eine hohe Stabilität gegenüber sichtbarem Licht und Temperaturerhöhungen besitzt. Bevorzugt wird vorliegend Pararosanilinnitril als Triphenylmethanfarbstoff verwendet, da mit diesem Farbstoff eine besonders deutliche Farbänderung erzielt werden kann, deren Intensität mit der eingestrahlten Dosis über einen großen Dosisbereich mathematisch definiert verläuft und die zudem stabil ist.

Als in ganz besonderem Maße vorteilhaft hat sich ein Mehrbereichsindikator herausgestellt, bei dem die photolatente Lewissäure des ersten Indikatorsystems zumindest eine photolatente Säure (nämlich eine Brønstedsäure) umfasst und der erste Indikatorfarbstoff des ersten Indikatorsystems zumindest einen säureempfindlichen Farbstoff aus der Gruppe der Fluorane umfasst, und bei dem der zweite Indikatorfarbstoff Pararosanilinnitril ist. Zusätzlich zu den zuvor beschriebenen günstigen Eigenschaften hat sich grade bei dieser besonderen Kombination des ersten Indikatorsystems und des zweiten Indikatorsystems gezeigt, dass die beiden Indikatorsysteme sich gegenseitig nicht beeinträchtigen und dass zudem die Verwendung des Indikatorsystems mit einem Fluoran und einer latenten Säure die Langzeitstabilität der Farbänderung des Pararosanilinnitrils signifikant verbessert. Die erzielbare Stabilität der Verfärbung des Pararosanilinfarbstoffs war hierbei nicht nur erheblich größer als bei Indikatormischungen, die jeweils nur eines der beiden Indikatorsysteme enthielten, es konnte darüber hinaus auch auf den Einsatz weiterer stabilisierender Hilfsstoffe in den Indikatorsystemen verzichtet werden, ohne dass dies zu einer Verringerung der Stabilität der Farbänderung führte.

Empfehlenswert ist es ferner, wenn das erste Indikatorsystem und/oder das zweite Indikatorsystem in dem Mehrbereichsindikator zu einem Anteil von jeweils mindestens 0,01 Gew.-% und höchstens 10 Gew.-% vorliegen. Ein derartiger Gehalt stellt auf der einen Seite sicher, das die auftretende Farbänderung bei den Indikatorfarbstoffen gut detektierbar ist, auf der anderen Seite ist dadurch gewährleistet, dass die Konzentrationen der Indikatorsysteme in dem Mehrbereichsindikator insgesamt hinreichend niedrig sind, so dass eine gleichmäßige Durchleuchtung der Probe erreicht wird und somit eine mit der eingestrahlten Dosis definiert einhergehende Farbänderung eintritt.

Schließlich bestand eine Aufgabe der vorliegenden Erfindung darin, ein Verfahren zur Verfügung zu stellen, das es ermöglicht, die auf einen Probenkörper eingestrahlte Dosis elektromagnetischer Strahlung parallel für mehrere Wellenlängenbereiche der Strahlung zu bestimmen. Diese Aufgabe wird durch ein Verfahren gelöst, bei dem zumindest ein Teil der Oberfläche des Probenkörpers mit dem zuvor beschriebenen Mehrbereichsindikator versehen wird und der Probenkörper dann elektromagnetischer Strahlung mit Wellenlängen aus dem ersten Strahlungswellenlängenbereich und aus dem zweiten Strahlungswellenlängenbereich ausgesetzt wird, bei dem die Änderung der Lichtabsorption des ersten Indikatorfarbstoffs und die Änderung der Lichtabsorption des zweiten Indikatorfarbstoffs im sichtbaren Bereich des Lichtspektrums erfasst werden und unter Verwendung von Kalibrierungswerten die Dosis der eingestrahlten elektromagnetischen Strahlung mit Wellenlängen aus dem ersten Strahlungswellenlängenbereich aus der Änderung der Lichtabsorption des ersten Indikatorfarbstoffs sowie die Dosis der eingestrahlten elektromagnetischen Strahlung mit Wellenlängen aus dem zweiten Strahlungswellenlängenbereich aus der Änderung der Lichtabsorption des zweiten Indikatorfarbstoffs unabhängig voneinander ermittelt werden. Bei Durchführung des erfindungsgemäßen Verfahrens ist es grundsätzlich möglich, auf einfache Weise gleichzeitig eine exakte und verlässliche Mehrbereichsbestimmung der Strahlungsdosis aus unterschiedlichen Wellenlängenbereichen durchzuführen, ohne dass hierfür zusätzliche Schritte wie ein abschließendes Entwickeln oder Fixieren der Indikatorfarbstoffe erforderlich ist, wobei die Mehrbereichsdetektion sogar *in situ* durchgeführt werden kann. Auf diese Weise kann eine kontinuierliche Mehrbereichs-Strahlungsdetektion realisiert werden.

Die Erfindung betrifft demnach die Verwendung eines Mehrbereichsindikators mit zumindest zwei Indikatorsystemen für die Bestimmung der Strahlendosis aus unterschiedlichen UV-Wellenlängenbereichen wie in Anspruch 1 definiert. Als Indikator wird jede Zusammensetzung mit wenigstens einem Indikatorsystem bezeichnet, die einen oder mehrere Prozesse irgendwelcher Art qualitativ oder quantitativ zu verfolgen gestattet, indem diese infolge einer chemischen Reaktion das Erreichen oder Verlassen eines bestimmten Zustands optisch detektierbar signalisiert. Als Indikatorsystem wird jede anwendbare Substanz oder Mischung von Substanzen bezeichnet, die einen einzigen Prozess qualitativ oder quantitativ zu verfolgen gestattet, indem diese infolge einer chemischen Reaktion das Erreichen oder Verlassen eines bestimmten Zustands optisch detektierbar signalisiert.

Im vorliegenden Fall handelt es sich ausschließlich um Indikatorsysteme für UV-Licht. Jedes der erfindungsgemäß verwendeten Indikatorsysteme ist hierbei für aktinische Strahlung aus lediglich einem bestimmten Wellenlängenbereich empfindlich.

Genauer gesagt weisen die verwendeten Indikatorsysteme nicht bloß das Vorhandensein der aktinischen Strahlung qualitativ nach, sondern zeigen vielmehr eine Veränderung, deren Ausmaß oder Intensität der insgesamt eingestrahlten Strahlungsmenge proportional ist. Die Strahlungsmenge entspricht hierbei der über die Einstrahldauer integrierten Intensität der in dem jeweiligen Wellenlängenbereich eingestrahlten aktinischen Strahlung, also einer auf das Indikatorsystem bezogenen Energiedosis dieser Strahlung.

Bei dem Indikator handelt es sich um einen UV-Mehrbereichsindikator, also um einen Indikator, der aktinische Strahlung aus zumindest zwei unterschiedlichen Wellenlängenbereichen nachweisen kann, wobei diese Bereiche zwar einen gewissen spektralen Überlappungsbereich aufweisen können, jedoch nicht vollständig identisch sind.

Als UV-Mehrbereichsindikator wird jeder Indikator bezeichnet, mittels dessen Strahlung aus zumindest zwei unterschiedlichen Wellenlängenbereichen nachgewiesen werden kann, wobei mindestens eines der darin enthaltenen Indikatorsysteme für Strahlung aus dem ultravioletten Bereich des Spektrums (etwa von 1 nm bis 380 nm) empfindlich ist und diese nachweisen kann, vorzugsweise sogar alle Indikatorsysteme.

Ein Mehrbereichsindikator mit zumindest zwei im UV-Bereich empfindlichen Indikatorsystemen kann erfindungsgemäß realisiert werden, indem beispielsweise der Indikator derart angepasst ist, dass die von dem ersten Indikatorsystem absorbierte elektromagnetische Strahlung und die von dem zweiten Indikatorsystem absorbierte elektromagnetische Strahlung jeweils Licht aus dem ultravioletten Bereich des Spektrums ist. Bezogen auf die konkrete Zusammensetzung des Mehrbereichsindikators beinhaltet eine derartige Anpassung, dass als photolatente Lewissäure bzw. -base des ersten Indikatorsystems eine Substanz eingesetzt wird, deren Absorptionsspektrum im UV-Bereich eine von Null verschiedene Absorption (entsprechend einer von 1,0 verschiedenen Transmission) aufweist. Infolge der Absorption dieses UV-Lichts setzt diese Substanz eine Lewissäure bzw. Lewisbase frei, die eine erste Farbänderung des ersten Indikatorfarbstoffs zur Folge hat. Der zweite Indikatorfarbstoff wird ferner dann derart gewählt, dass er infolge einer UV-Lichtabsorption des UV-Mehrbereichsindikators eine zweite Farbänderung durchläuft, vorzugsweise, indem als zweiter Indikatorfarbstoff ein Farbstoff eingesetzt wird, dessen Absorptionsspektrum im UV-Bereich eine von Null verschiedene Absorption aufweist und dessen Struktur sich infolge der Aufnahme von UV-Licht in einer chemischen Reaktion ändert.

Das erste Indikatorsystem des verwendeten Mehrbereichsindikators weist hierbei einen ersten Indikatorfarbstoff und eine photolatente Lewissäure oder eine photolatente Lewisbase auf.

Bei der photolatenten Lewissäure oder photolatenten Lewisbase handelt es sich um eine photochemisch aktiv Substanz, das heißt, um eine Substanz, die in der Lage ist, aus eingestrahltem Licht derart Energie aufzunehmen, dass diese Substanz infolge der Energieaufnahme in einer chemischen Reaktion verändert wird und dabei eine photolatente Lewissäure oder photolatente Lewisbase freisetzt. Dazu weist die photolatente Lewissäure oder photolatente Lewisbase bei den Wellenlängen des aktinischen Lichts, deren Dosis jeweils zu überwachen ist, eine von Null verschiedene Absorption auf, so dass die aktinische Strahlung vollständig oder zumindest teilweise von der photolatenten Lewissäure oder photolatenten Lewisbase absorbiert wird und diese in einen energetisch angeregten Zustand überführt. Der energetisch angeregte Zustand hat die Freisetzung der Lewissäure oder Lewisbase zur Folge. Hierdurch wird die Konzentration an freier Lewissäure oder Lewisbase in dem Mehrbereichsindikator lokal erhöht, was in einer Veränderung der Absorptionseigenschaften des Indikatorfarbstoffs resultiert. Da diese Absorptionsänderung des Indikatorfarbstoffs bei Wellenlängen im sichtbaren Bereich des Spektrums erfolgt, ist es möglich, die Absorptionsänderung visuell zu verfolgen.

Das erste Indikatorsystem enthält zusätzlich zu der photolatenten Lewissäure oder photolatenten Lewisbase einen ersten Indikatorfarbstoff, der auf die photolatente Lewissäure oder photolatente Lewisbase abgestimmt ist, also einen korrespondierenden Indikatorfarbstoff.

Als photolatente Lewissäure oder photolatente Lewisbase des ersten Indikatorsystems kommt grundsätzlich jede Substanz in Frage, die zumindest in einem Wellenlängenbereich der aktinischen Strahlung eine von Null verschiedene Absorption aufweist und die darüber hinaus in der Lage ist, infolge der Absorption der aktinischen Strahlung eine Lewissäure oder Lewisbase freizusetzen, das heißt in einer chemischen Reaktion zu erzeugen oder anderweitig als freie Verbindung zur Verfügung zu stellen, beispielsweise in einem Desorptionsschritt oder aus einem Lewisaddukt. Bei der Lewissäure oder Lewisbase kann es sich beispielsweise um einen von der photolatenten Lewissäure oder photolatenten Lewisbase abgespaltenen Teil handeln.

Als Lewissäuren werden alle elektrophilen Elektronenpaarakzeptoren verstanden, also alle Substanzen, die Elektronenpaare anlagern können, beispielsweise Moleküle und Ionen mit unvollständiger Edelgaskonfiguration, also einer Elektronenlücke. Insbesondere gelten als Lewissäuren im Sinne dieser Erfindung auch Brønstedsäuren (klassische Säuren; Protonensäuren), das heißt Substanzen, die Protonendonatoren sind oder diese enthalten, wobei hierunter auch Protonen selber zu verstehen sind.

Entsprechend hierzu werden als Lewisbasen alle nucleophilen Elektronenpaardonatoren verstanden, also alle Substanzen, die Elektronenpaare abgeben können. Insbesondere gelten als Lewisbasen im Sinne dieser Erfindung auch Brønstedbasen (klassische Basen), das heißt Substanzen, die Protonenakzeptoren sind oder diese enthalten, wobei hierunter auch Hydroxidionen selber zu verstehen sind.

Beispiele für einsetzbare photolatente Lewissäuren sind etwa aus WO 02/101462 A1 und WO 2005/097876 A1 bekannt, auf die hier ausdrücklich Bezug genommen wird.

Als latente Lewissäuren kommen gemäß WO 2005/097876 A1 insbesondere solche in Frage, die auf einer Verbindung der allgemeinen Formel R¹- CH^{*}R⁰-(A6)R²R³R⁴R⁵-OH basieren. Dabei stellt A6 ein aromatisches Ringsystem mit sechs Ringatomen dar, das optional ein Heteroatom oder mehrere Heteroatome und/oder weitere annellierte Ringe enthalten kann. R¹ wird gewählt aus der Gruppe umfassend Wasserstoff, Alkylgruppen (insbesondere C₁-C₂₀-Alkylgruppen), Alkenylgruppen (insbesondere C₂-C₂₀-Alkenylgruppen), Arylgruppen (insbesondere unsubstituierte sowie einfach, zweifach oder dreifach mit C₁-C₄-Alkylgruppen substituierte Phenylgruppen, oder C₁- C₄-Alkoxygruppen. R², R³, R⁴ sowie R⁵ werden unabhängig voneinander gewählt aus der Gruppe umfassend Wasserstoff oder funktionale Substituenten. R⁰ wird gewählt aus der Gruppe umfassend C₁-C₆-Alkylgruppen, oder Gruppen der allgemeinen Formel -Z¹-Q¹ oder -Z²-Q². Z¹ stellt dabei eine Einfachbindung dar oder ein verbrückendes Schwefelatom (-S-) oder Sauerstoffatom (-O-) oder eine verbrückende sekundäre Amingruppe (-NH-). Q¹ stellt dabei ein heterocyclisches Ringsystem mit 5 bis 9 Ringatomen dar, dessen Ringatome Kohlenstoff (C), Schwefel (S), Sauerstoff (O) und Stickstoff (N) sein können, wobei das Ringsystem zumindest zwei, bevorzugt drei, besonders bevorzugt wenigstens vier Kohlenstoffatome enthält. Insbesondere repräsentiert Q¹ Morpholin, Pyridin (das gegebenenfalls einfach bis dreifach mit C₁-C₂-Alkylgruppen oder Hydroxylgruppen substituiert sein kann), Mercaptobenzoxazol oder Mercaptobenzthiazol. Z² steht für eine C₁-C₄-Alkylengruppe, die mit einer C₁-C₄-Alkylgruppe oder mit Q³ substituiert sein kann. Q² u n d Q³ stellen hierbei unabhängig voneinander Phenylgruppen dar, die gegebenenfalls einfach bis dreifach mit C₁-C₄-Alkylgruppen, Hydroxylgruppen, C₅-C₈-Cycloalkylgruppen und/oder einem heterocyclischen Ringsystem mit 5 bis 9 Ringatomen substituiert sein können, dessen Ringatome Kohlenstoff (C), Schwefel (S), Sauerstoff (O) und Stickstoff (N) sein können, wobei das Ringsystem zumindest zwei, bevorzugt drei, besonders bevorzugt wenigstens vier Kohlenstoffatome enthält. Darüber hinaus kann das Wasserstoffatom H^{*}, das an dem Kohlenstoffatom in Bezug auf den Substituenten R⁰ in alpha-Stellung gebunden ist, bei Einwirkung von elektromagnetischer Strahlung in einer photochemischen Reaktion als Proton abgespalten werden.

Spezifische Beispiele für photolatente Lewissäuren sind in W0 02/101462 A1 beschrieben, die, ohne sich durch diese Beispiele einzuschränken, ausnahmslos eingesetzt werden können.

Als photolatente Säuren können ebenfalls die in EP 2003/050912 beschriebenen phenolischen Antioxidantien eingesetzt werden. Typische Beispiele hierfür sind etwa Verbindungen aus der Gruppe der Hydroxyphenylbenzotriazole, der Hydroxyphenyltriazine oder der Hydroxybenzophenone, die allesamt eine Hydroxylgruppe aufweisen, die an einem Phenylring in Bezug auf die Bindung zwischen dem Phenylring und dem Molekülhauptgerüst in ortho-Stellung angeordnet sind.

Beispiele für einsetzbare photolatente Lewisbasen sind etwa aus EP 0 970 085, WO 03/033500 und WO 2008/009575 A2 bekannt, auf die hier ausdrücklich Bezug genommen wird. Insbesondere einsetzbar sind die von der allgemeinen Struktur (I) in WO 2008/009575 A2 abgedeckten Aminoverbindungen.

In dem ersten Indikatorsystem können zusätzlich zu der ersten photolatenten Lewissäure bzw. -base auch weitere photolatente Lewissäuren bzw. -basen vorliegen, um aktinische Strahlung aus einem größeren Wellenlängenbereich oder aus mehreren voneinander getrennten Wellenlängenbereichen integral mit dem ersten Indikatorsystem nachweisen zu können.

Die aus den photolatenten Lewissäuren oder Lewisbasen freigesetzten Lewissäuren oder Lewisbasen (insbesondere Protonen oder Hydroxidionen) treten mit dem ersten Indikatorfarbstoff in Wechselwirkung und haben damit eine Änderung der Absorption des ersten Indikatorfarbstoffs zur Folge. Entsprechend den jeweils eingesetzten photolatenten Lewissäuren oder Lewisbasen muss der erste Indikatorfarbstoff also als lewissäureempfindlicher Farbstoff oder als lewisbaseempfindlicher Farbstoff ausgebildet sein, insbesondere als säureempfindlicher Farbstoff oder als baseempfindlicher Farbstoff. Demzufolge kommen als erster Indikatorfarbstoff beispielsweise grundsätzlich alle bekannten pH-Indikatorfarbstoffe in Frage, die eine Farbveränderung in Abhängigkeit von der Protonenkonzentration zeigen.

Besonders bevorzugt sind als erste Indikatorfarbstoffe jedoch Farbstoffe, die als Grundgerüst eine von Fluoran (Spiro[isobenzofuran-1,9'-xanthen]-3-on) abgeleitete Struktur aufweisen, die so genannten "Fluorane". Beispiele für erfindungsgemäß einsetzbare säureempfindliche Fluorane sind etwa aus WO 2005/097876 A1 bekannt, auf die hier ausdrücklich Bezug genommen wird.

So sind insbesondere bevorzugte Fluorane, ohne sich durch diese Aufzählung einschränken zu wollen, 3-Dibutylamino-7-dibenzylaminofluoran, 3-Diethylamino-6-methylfluoran, 3-Dimethylamino-6-methyl-7-anilinofluoran, 3-Diethylamino-6-methyl-7-anilinofluoran, 3-Diethylamino-6-methyl-7-(2,4-dimethylanilino)fluoran, 3-Diethylamino-6-methyl-7-chlorofluoran, 3-Diethylamino-6-methyl-7-(3-trifluoromethylanilino)fluoran, 3-Diethylamino-6-methyl-7-(2-chloroanilino)fluoran, 3-Diethylamino-6-methyl-7-(4-chloroanilino)fluoran, 3-Diethylamino-6-methyl-7-(2-fluoroanilino)fluoran, 3-Diethylamino-6-methyl-7-(4-n-octylanilino)fluoran, 3-Diethylamino-7-(4-n-octylanilino)fluoran, 3-Diethylamino-6-methyl-7-(dibenzylamino)fluoran, 3-Diethylamino-7-(dibenzylamino)fluoran, 3-Diethylamino-6-chloro-7-methylfluoran, 3-Diethylamino-7-t-butylfluoran, 3-Diethylamino-7-carboxyethylfluoran, 3-Diethylamino-6-chloro-7-anilinofluoran, 3-Diethylamino-6-methyl-7-(3-methylanilino)fluoran, 3-Diethylamino-6-methyl-7-(4-methylanilino)fluoran, 3-Diethylamino-6-ethoxyethyl-7-anilinofluoran, 3-Diethylamino-7-methylfluoran, 3-Diethylamino-6,8-dimethylfluoran, 3-Diethylamino-7-chlorofluoran, 3-Diethylamino-7-chlorofluoran, 3-Diethylamino-7-(3-trifluoromethylanilino)fluoran, 3-Diethylamino-7-(2-chloroanilino)fluoran, 3-Diethylamino-7-(2-fluoroanilino)fluoran, 3-Diethylamino-benzo[a]fluoran, 3-Diethylamino-benzo[c]fluoran, 3-Dibutylamino-6-methylfluoran, 3-Dibutylamino-6-methyl-7-anilinofluoran, 3-Dibutylamino-6-methyl-7-(2,4-dimethylanilino)fluoran, 3-Dibutylamino-6-methyl-7-(2-chloroanilino)fluoran, 3-Dibutylamino-6-methyl-7-(4-chloroanilino)fluoran, 3-Dibutylamino-6-methyl-7-(2-fluoroanilino)fluoran, 3-Dibutylamino-6-methyl-7-(3-trifluoromethylanilino)fluoran, 3-Dibutylamino-6-ethoxyethyl-7-anilinofluoran, 3-Dibutylamino-6-chloro-anilinofluoran, 3-Dibutylamino-6-methyl-7-(4-methylanilino)fluoran, 3-Dibutyamino-7-(2-chloroanilino)fluoran, 3-Dibutylamino-7-(2-fluoroanilino)fluoran, 3-Dipentylamino-6-methyl-7-anilinofluoran, 3-Dipentylamino-6-methyl-7-(4-2-chloroanilino)fluoran, 3-Dipentylamino-7-(3-trifluoromethylanilino)fluoran, 3-Dipentylamino-6-chloro-7-anilinofluoran, 3-Dipentylamino-7-(4-chloroanilino)fluoran, 3-Pyrrolidino-6-methyl-7-anilinofluoran, 3-Piperidino-6-methyl-7-anilinofluoran, 3-(N-Methyl-N-propylamino)-6-methyl-7-anilinofluoran, 3-(N-methyl-N-cyclohexylamino)-6-methyl-7-anilinofluoran,3-(N-Ethyl-N-cyclohexylamino)-6-methyl-7-anilinofluoran, 3-(N-Ethyl-N-n-hexylamino)-7-anilinofluoran, 3-(N-Ethyl-p-toluidino)amino-6-methyl-7-anilinofluoran,3-(N-Ethyl-p-toluidino)amino-7-methylfluoran, 3-(N-Ethyl-N-isoamyl-amino)-6-methyl-7-anilinofluoran, 3-(N-Ethyl-N-isoamylamino)-7-(2-chloroanilinofluoran, 3-(N-Ethyl-N-isoamylamino)-6-chloro-7-anilinofluoran, 3-(N-Ethyl-N-tetrahydrofurfurylamino)-6-methyl-7-anilinofluoran, 3-(N-Ethyl-N-isobutylamino)-6-methyl-7-anilinofluoran, 3-(N-Butyl-N-isoamylamino)-6-methyl-7-anilinofluoran, 3-(N-Isopropyl-N-3-pentylamino)-6-methyl-7-anilino-fluoran, 3-(N-Ethyl-N-ethoxypropylamino)-6-methyl-7-anilinofluoran, 3-Cyclohexylamino-6-chlorofluoran, 2-Methyl-6-p-(p-dimethylaminophenyl)aminoanilinofluoran, 2-Methoxy-6-p-(p-dimethylaminophenyl)aminoanilinofluoran, 2-Chloro-3-methyl-6-p-(p-phenylaminophenyl)-aminoanilinofluoran, 2-Diethylamino-6-p-(p-dimethylaminophenyl)aminoanilinofluoran, 2-Phenyl-6-methyl-6-p-(p-phenylaminophenyl)aminoanilinofluoran, 2-Benzyl-6-p-(p-phenylaminophenyl)aminoanilinofluoran, 3-Methyl-6-p-(p-dimethylaminophenyl)aminoanilinofluoran, 3-Diethylamino-6-p-(p-diethylaminophenyl)aminoanilinofluoran, 3-Diethylamino-6-p-(p-dibutylaminophenyl)aminoanilinofluoran, 2,4-Dimethyl-6-[(4-dimethylamino)anilino]fluoran, 3-Diethylamino-6-methylfluoran, 3-Diethylamino-6-methyl-7-anilinofluoran, 3-Diethylamino-6-methyl-7-(2,4-dimethylanilino)fluoran, 3-Diethylamino-6-methyl-7-chlorofluoran, 3-Diethylamino-6-methyl-7-(3-trifluoromethylanilino)fluoran, 3-Diethylamino-6-methyl-7-(2-chloroanilino)fluoran, 3-Diethylamino-6-methyl-7-(4-chloro-anilino)fluoran, 3-Diethylamino-6-methyl-7-(2-fluoroanilino)fluoran, 3-Diethylamino-7-(4-n-octylanilino)fluoran, 3-Diethylamino-7-(dibenzylamino)fluoran, 3-Diethylamino-6-chloro-7-methylfluoran, 3-Diethylamino-7-t-butylfluoran, 3-Diethylamino-7-carboxyethylfluoran, 3-Diethylamino-6-Chloro-7-anilinofluoran, 3-Diethylamino-6-methyl-7-(3-methylanilino)fluoran, 3-Diethylamino-6-methyl-7-(4-methylanilino)fluoran, 3-Diethylamino-7-methylfluoran, 3-Diethylamino-6,8-dimethylfluoran, 3-Diethylamino-7-chlorofluoran, 3-Diethylamino-7-(3-trifluoro-methylanilino)fluoran, 3-Diethylamino-7-(2-chloroanilino)fluoran, 3-Diethylamino-7-(2-fluoro-anilino)fluoran, 3-Diethylamino-benzo[a]fluoran-6-ethoxyethyl-7-anilinofluoran, 3-Dibutylamino-6-chloro-anilinofluoran, 3-Dipentylamino-6-methyl-7-anilinofluoran, 3-(N-Methyl-N-propylamino)-6-methyl-7-anilinofluoran, 3-(N-Methyl-N-cyclohexylamino)-6-methyl-7-anilino-fluoran,3-(N-Ethyl-N-cyclohexylamino)-6-methyl-7-anilinofluoran, 3-(N-Ethyl-N-n-hexylamino)-7-anilinofluoran, 3-(N-Ethyl-p-toluidino)amino-6-methyl-7-anilinofluoran, 3-(N-Ethyl-p-toluidino)amino-7-methylfluoran, 3-(N-Ethyl-N-isoamylamino)-6-methyl-7-anilinofluoran, 3-(N-Ethyl-N-tetrahydrofurfurylamino)-6-methyl-7-anilinofluoran, 3-(N-Ethyl-N-isobutylamino)-6-methyl-7-anilinofluoran, 3-(N-Butyl-N-isoamylamino)-6-methyl-7-anilinofluoran, 3-(N-Isopropyl-N-3-pentylamino)-6-methyl-7-anilinofluoran,3-(N-Ethyl-N-ethoxypropylamino)-6-methyl-7-anilinofluoran, 3-Cyclohexylamino-6-chlorofluoran, 7-(N-Ethyl-N-isopentylamino)-3-methyl-1-phenylspiro[4H-chromenopyrazol-4-(1H)-3'-phthalid, 3-Diethylamino-6-methyl-7-anilinofluoran, 3-Diethylamino-6-methyl-7-(2,4-dimethylanilino)fluoran, 3-Diethylamino-6-methyl-7-chlorofluoran, 3-Diethylamino-7-(4-n-octylanilino)fluoran, 3-Diethylamino-7-(dibenzylamino)fluoran, 3-Diethylamino-7-t-butylfluoran, 3-Diethylamino-7-carboxyethylfluoran, 3-Diethylamino-6,8-dimethylfluoran, 3-Diethylamino-benzo[a]fluoran, 3-Diethylamino-benzo[c]fluoran, 3-Dibutylamino-6-methyl-7-anilinofluoran, 3-Dipentylamino-6-methyl-7-anilinofluoran, 3-(N-Methyl-N-propylamino)-6-methyl-7-anilinofluoran, 3-(N-Methyl-N-cyclohexylamino)-6-methyl-7-anilinofluoran, 3-(N-Ethyl-p-toluidino)amino-7-methylfluoran, 3-(N-Ethyl-N-isoamylamino)-6-methyl-7-anilinofluoran, 3-(N-Ethyl-N-isobutylamino)-6-methyl-7-anilinofluoran, 3-(N-Ethyl-N-ethoxypropylamino)-6-methyl-7-anilinofluoran, 3-Cyclohexylamino-6-chlorofluoran und 7-(N-Ethyl-N-isopentylamino)-3-methyl-1-phenylspiro[4H-chromenopyrazol-4-(1H)-3'-phthalid.

Kommerziell erhältliche Fluorane werden beispielsweise unter den Bezeichnungen Pergascript Black T-R, Pergascript Black T-2R, Pergascript Green 1-2GN, Pergascript Orange I-G, Pergascript blue I-2RN, Orange DCF, Red DCF, Orange 100, Red PSD-V, Red ETPM vertrieben.

Anstelle von Fluoranen ist es natürlich auch möglich, andere Farbstoffe als ersten Indikatorfarbstoff einzusetzen, beispielsweise solche auf der Basis von Lactonen, Benzoxazines, Spiropyranen oder Phthaliden.

Grundsätzlich lassen sich für das erste Indikatorsystem beliebige lewissäureempfindliche Indikatorfarbstoffe mit beliebigen photolatenten Lewissäuren oder beliebige lewisbaseempfindliche Indikatorfarbstoffe mit beliebigen photolatenten Lewisbasen kombinieren. Die Auswahl der konkret einzusetzenden photolatenten Lewissäure oder photolatenten Lewisbase sollte die jeweilige konkrete Anwendung berücksichtigen und dabei insbesondere entsprechend den Wellenlängen des zu überwachenden Wellenlängenbereichs erfolgen. Ferner kann das erste Indikatorsystem auch mehr als einen Indikatorfarbstoff enthalten, etwa, um einen besonders kontrastreichen Farbumschlag zu bieten. Die Dosisbestimmung kann hierbei aus der Summe der Einzeldosen für jeden der Indikatorfarbstoffe des ersten Indikatorsystems erfolgen.

Bei den erfindungsgemäß verwendeten Indikatorsystemen sind üblicherweise der Indikatorfarbstoff und die photolatente Lewissäure oder die photolatente Lewisbase als unterschiedliche Verbindungen realisiert. In einer besonderen Ausgestaltung können jedoch die photolatente Lewissäure bzw. -base und der Indikatorfarbstoff als eine einzige Verbindung realisiert sein. Eine derartige Ausgestaltung könnte etwa darin bestehen, dass der Indikatorfarbstoff und die photolatente Lewissäure oder photolatente Lewisbase des Indikatorsystems als Bestandteile eines polymeren Grundgerüsts miteinander über das Polymergerüst verbunden sind und somit in dasselbe Polymer einpolymerisiert sind, etwa als Copolymere oder in einer nachträglichen Pfropfreaktion.

Zusätzlich zu dem ersten Indikatorsystem weist der in der Erfindung verwendete Mehrbereichsindikator ein zweites Indikatorsystem auf. Das zweite Indikatorsystem umfasst einen zweiten Indikatorfarbstoff und ist zu einer Änderung der Lichtabsorption des zweiten Indikatorfarbstoffs in einer zweiten Reaktion bei Einwirkung von elektromagnetischer Strahlung mit Wellenlängen aus einem zweiten Strahlungswellenlängenbereich in der Lage. Als zweites Indikatorsystem kommen grundsätzlich alle derartigen Indikatorsysteme in Frage, bei denen der zweite Indikatorfarbstoff ein Triphenylmethanfarbstoff ist, in dem das zentrale C-Atom der Methangruppe mit einer Struktureinheit ausgewählt aus der Gruppe umfassend Halogene, Pseudohalogene, Chalkogene, Sulfate und substituierte oder unsubstituierte Tosylate verbunden ist, und in dem zumindest einer der C₆-Ringe der Phenylgruppen in ortho- oder para-Stellung zu der Bindung zu dem zentralen Methyl-C-Atom einen elektronenziehenden Substituenten mit einem +M-Effekt und/oder in meta-Stellung zu der Bindung zu dem zentralen Methyl-C-Atom einen elektronenschiebenden Substituenten mit einem +M-Effekt aufweist.

Als Triphenylmethanfarbstoff (Triarylmethanfarbstoff) werden alle Farbstoffe mit einem Grundgerüst verstanden, die sich von Triphenylmethan [(H₅C₆)₃C-H] herleiten. Da die Methylgruppe des Triphenylmethanfarbstoffs zusätzlich zu den Phenylgruppen einen weiteren Substituenten aufweist, können von den bekannten Triphenylmethanfarbstoffen lediglich reduzierte Formen eingesetzt werden, beispielsweise solche Farbstoffe, die sich von den Triarylcarbinolen wie etwa Rosanilin [(4-Amino-3-methylphenyl)-bis-(4-aminophenyl)-methanol] oder Pararosanilin [Tris(4-aminophenyl)-methanol] herleiten oder aber auf die Leukobasen der oxidierten Farbstoffe zurückzuführen sind, etwa die Leukobasen von Doebners Violett, Malachitgrün, Brilliantgrün, Patentblau VF, Fuchsin, Parafuchsin, Säurefuchsin, Neufuchsin, Hoffmanns Violett, Methylviolett, Kristallviolett, Methylblau, Methylgrün, Anilinblau, Wasserblau, Alkaliblau oder Aurin.

Zumindest eine der drei Phenylgruppen liegt substituiert vor, wobei diese einfach substituiert oder auch mehrfach substituiert sein kann. Vorzugsweise liegen jedoch mehr als eine Phenylgruppe substituiert vor, also zwei Phenylgruppen (wie etwa bei den Leukobasen der Diamino-triarylmethanfarbstoffe Doebners Violett, Malachitgrün, Brilliantgrün, Patentblau VF) oder alle drei Phenylgruppen (wie etwa bei Rosanilin, Pararosanilin oder den Leukobasen von Fuchsin, Parafuchsin, Säurefuchsin, Neufuchsin, Hoffmanns Violett, Methylviolett, Kristallviolett, Methylblau, Methylgrün, Anilinblau, Wasserblau, Alkaliblau oder Aurin). Dabei ist es jeweils möglich, dass die drei Phenylgruppen des Triphenylmethanfarbstoffs identisch sind (wie etwa beim Pararosanilin) oder aber unterschiedlich sind (wie etwa beim Rosanilin).

Als Substituenten des C₆-Rings einer Phenylgruppen kommen solche in Frage, die einen +M-Effekt (mesomeren Effekt vom Typ "+") aufweisen. Substituenten, die einen mesomeren Effekt aufweisen, nehmen selber an der Mesomerie eines mit diesen Gruppen verbundenen aromatischen Ringsystems teil, so dass das mesomere System durch diese Substituenten vergrößert wird. Substituenten, die einen +M-Effekt zeigen, weisen in der Regel zumindest ein freies Elektronenpaar auf, das für die Mesomerie zur Verfügung gestellt werden kann. Hierdurch wird die Elektronendichte des mesomeren Systems insgesamt erhöht. Typische Substituenten mit einem +M-Effekt sind beispielsweise - ohne sich durch die Aufzählung einzuschränken - unsubstituierte oder substituierte Arylgruppen, Aminogruppen (-NH₂), Amingruppen (mono und di; -NHR bzw. -NR₂), Hydroxylgruppen (protoniert und deprotoniert; -OH bzw. -O-), Ethergruppen (-OR), Estergruppen (-OCOR), Säureamidgruppen (-NHCOR), Acrylsäuregruppen (-CH=CH-COOH) oder Halogene wie Fluor (-F), Chlor (-Cl), Brom (-Br) oder Jod (-I), wobei R jeweils für einen beliebigen unsubstituierten oder substituierten organischen Rest steht.

Befindet sich der Substituent mit dem +M-Effekt im Hinblick auf die Bindung des C₆-Rings der Phenylgruppe mit dem zentralen Methyl-C-Atom in ortho-Stellung oder in para-Stellung, so muss es sich zusätzlich um einen elektronenziehenden Substituenten handeln. Befindet sich der Substituent hingegen in meta-Stellung, so muss es sich zusätzlich um einen elektronenschiebenden Substituenten handeln. Als elektronenschiebend bzw. elektronenziehend werden Substituenten bezeichnet, die einen positiven bzw. negativen induktiven Effekt aufweisen (+I-Effekt bzw. -I-Effekt). Ein induktiver Effekt tritt auf, wenn Elektronegativitätsunterschiede zwischen Atomen oder funktionellen Gruppen eines Moleküls eine dazwischen liegende sigma-Elektronenpaarbindung polarisieren.

Bei einem positiven induktiven Effekt schiebt ein elektropositiverer Substituent die Elektronenpaarbindung von sich weg und erhöht damit Elektronendichte an dem benachbarten elektronegativeren Grundgerüst. Dies geschieht etwa, wenn der Substituent negativ geladen ist, eine niedrige Elektronegativität besitzt oder hybridisiert (also mit Hybridorbitalen) vorliegt. Typische elektronenschiebende Substituenten sind beispielsweise - ohne sich durch die Aufzählung einzuschränken - tert-Butylgruppen (-C(CH₃)₃), iso-Propylgruppen (-CH(CH₃)₂), Ethylgruppen (-C₂H₅), Methylgruppen (-CH₃), deprotonierte Hydroxylgruppen (-O-) oder Alkylgruppen (-R).

Im Gegensatz dazu zieht bei einem negativen induktiven Effekt ein elektronegativerer Substituent die Elektronenpaarbindung stärker zu sich hin und verringert damit Elektronendichte an dem benachbarten elektropositiveren Grundgerüst. Dies geschieht etwa, wenn der Substituent positiv geladen ist oder eine große Elektronegativität besitzt. Typische elektronenziehende Substituenten sind beispielsweise - ohne sich durch die Aufzählung einzuschränken - protonierte Hydroxylgruppen (-OH), Carboxylgruppen (-COOH), Nitrogruppen (-NO₂), Aminogruppen (-NH₂), Phenylgruppen (-C₆H₅) oder Halogene wie Fluor (-F), Chlor (-Cl), Brom (-Br) oder Jod (-I). Keinen induktiven Effekt zeigt das Wasserstoffatom (-H).

Schließlich ist es erforderlich, dass der zweite Indikatorfarbstoff ein Triphenylmethanfarbstoff ist, an dessen zentralem C-Atom der Methangruppe eine Struktureinheit direkt gebunden ist, die sich in einer photochemischen Reaktion leicht von dem Triphenylmethanfarbstoff abspalten lässt. Hierzu wird die Struktureinheit ausgewählt aus der Gruppe umfassend Halogene (beispielsweise Fluor (-F), Chlor (-Cl), Brom (-Br) oder Jod (-I)), Pseudohalogene (beispielsweise Nitrilgruppen (-CN), Azidgruppen (-N₃), Cyanatgruppen (-OCN), Isocyanatgruppen (-NCO), Nitriloxidgruppen (-CNO), Thiocyanatgruppen (-SCN), Thioisocyanatgruppen (-NCS) oder Selenocyanatgruppen (-SeCN)), substituierte oder unsubstituierte Tosylate (die sich von der Toluolsulfonsäure -O-SO₂-C₆H₄-CH₃ ableiten), Sulfat (-O-SO₂-O- und dessen Derivate Hydrogensulfat - O-SO₂-OH und Schwefelsäureestergruppen -O-SO₂-OR, in denen das Sulfat ebenfalls direkt an das zentrale C-Atom der Methangruppe des Farbstoff gebunden ist, wobei R jeweils für einen beliebigen unsubstituierten oder substituierten organischen Rest steht), sowie Chalkogene (etwa Sauerstoff, Schwefel oder Selen, die das zentrale C-Atom der Methangruppe des Triphenylmethanfarbstoffs mit einem weiteren Rest verbinden, also beispielsweise Hydroxylgruppen (-OH), Ethergruppen (-OR), Estergruppen (-O-CO-R), Thiolgruppen (-SH), Thioethergruppen (-SR), Thioestergruppen (-S-CO-R)), ohne sich durch die vorstehenden Aufzählungen konkret benannter Beispiele einzuschränken.

Grundsätzlich lässt sich als zweiter Indikatorfarbstoff eine beliebige Verbindung einsetzen, die die obigen Vorrausetzungen erfüllt. Die praktische Auswahl eines konkreten zweiten Indikatorfarbstoffs sollte dabei die jeweilige spezifische Anwendung berücksichtigen und dabei insbesondere entsprechend den Wellenlängen der zu überwachenden Wellenlängenbereiche einerseits und der Zusammensetzung des ersten Indikatorsystems andererseits entsprechend erfolgen.

Als bevorzugt einsetzbares Beispiel sei Pararosanilinnitril benannt, in dem die drei Phenylgruppen jeweils in para-Stellung zu der Bindung zu dem zentralen Methyl-C-Atom als elektronenziehende Substituenten Aminogruppen aufweisen und in dem die mit dem zentralen C-Atom der Methangruppe verbundene Struktureinheit eine Cyanogruppe (Nitrilgruppe) ist. Der vor einer Bestrahlung transparente Farbstoff Pararosanilinnitril absorbiert elektromagnetische Strahlung aus dem UVB- und UVC-Bereich. Infolge der dabei ablaufenden photochemischen Reaktion nimmt die Absorption im sichtbaren Bereich des Spektrums zu (mit einem Maximum bei etwa 550 nm), so dass der Farbstoff rot gefärbt wird.

Dosismesssysteme auf der Basis von Leukocyaniden von Pararosanilin (Pararosanilinnitril) oder dessen Derivaten sind bereits aus McLaughlin et al.: "Radiochromic Plastic Films for Accurate Measurement of Radiation Absorbed Dose and Dose Distribution" Radiat. Phys. Chem. Vol. 10, 119-125 (1977) sowie aus McLaughlin et al.: "The Gamma-Ray Response of Radiochromic Dye Films at Different Absorbed Dose Rates" Radiat. Phys. Chem. Vol. 18 No. 5-6, 987-999 (1981), Rativanich et al.: "Liquid Radiochromic Dosimetry" Radiat. Phys. Chem. Vol. 18 No. 5-6, 1001-1010 (1981), Uribe et al.: "Possible Use of Electron Spin Resonance of Polymer Films Containing Leukodyes for Dosimetry" Radiat. Phys. Chem. Vol. 18 No. 5-6, 1011-1016 (1981), Buenfil-Burgos et al.: "Thin Plastic Radiochromic Dye Films as lonizing Radiation Dosimeters" Radiat. Phys. Chem. Vol. 22 No. 3-5, 325-332 (1983) oder Schönbacher et al.: "Colour Dosemeters for High Level Radiation Dosimetry", Radiation Protection Dosimetry, Vol. 34, No. 1/4, 311-314 (1990) bekannt.

Anwendungen von Pararosanilinnitril als Indikatorfarbstoff sind im Stand der Technik beschrieben, etwa in DE 10 2004 022 071 A1, auf deren Inhalt im Hinblick auf für im Sinne der vorliegenden Erfindung einsetzbare Systeme hiermit Bezug genommen wird. In DE 10 2004 022 071 ist ein Dosismessfilm für Elektronenstrahlen beschrieben. Hierbei handelt es sich um einen Verbund aus einer 20 µm dicken strahlenempfindlichen Schicht auf einem 50 µm dicken Polyesterfilm, wobei die strahlenempfindliche Schicht im Wesentlichen einen Polyesterlack und ein Leukocyanid von Pararosanilin (Pararosanilinnitril) als strahlenempfindlichen Farbstoff enthält. Zur Herstellung des Messfilms werden die gelösten Bestandteile der Schicht auf den Polyesterfilm aufgetragen und das Lösungsmittel in einer Trockenstufe entfernt.

Somit enthält der erfindungsgemäß verwendete Mehrbereichsindikator ein erstes Indikatorsystem und ein zweites Indikatorsystem. Im einfachsten Fall weist der Mehrbereichsindikator darüber hinaus keine weiteren Bestandteile auf. Natürlich kann der Mehrbereichsindikator aber auch weitere Bestandteile enthalten, beispielsweise weitere Indikatorsysteme oder Hilfsstoffe.

Zur Realisierung des UV-Mehrbereichsindikators kann dabei das erste Indikatorsystem zur Absorption von Licht aus dem UVA-Bereich des Spektrums und das zweite Indikatorsystem zur Absorption von Licht aus dem UVB- und/oder dem UVC-Bereich des Spektrums des Spektrums in der Lage sein. Dies beinhaltet, dass als photolatente Lewissäure bzw. -base des ersten Indikatorsystems eine Substanz verwendet wird, die Licht aus dem UVA-Bereich des Spektrums absorbiert und somit dort eine von Null verschiedene Absorption aufweist, während der zweite Indikatorfarbstoff des zweiten Indikatorsystems Licht aus dem UVB-Bereich des Spektrums, Licht aus dem UVC-Bereich des Spektrums oder Licht sowohl aus dem UVB-Bereich als auch aus dem UVC-Bereich des Spektrums absorbiert.

Im Hinblick auf eine leichtere Handhabung des Mehrbereichsindikators ist es zudem wünschenswert, wenn das Indikatorsystem für den UVA-Bereich einen spektral schmalen Übergang besitzt, so dass dieses Indikatorsystem im blauen Bereich des Spektrums des sichtbaren Lichts (also bei Wellenlängen oberhalb von 450 nm oder vorzugsweise oberhalb von 400 nm) eine allenfalls geringe Absorption aufweist, so dass nicht bereits eine Absorption von Tageslicht eine Farbänderungsreaktion auslöst. Substanzen mit derartiger Absorption sind aus dem Stand der Technik für den UVA-Bereich, den UVB-Bereich und den UVC-Bereich hinreichend bekannt.

Die bei dem ersten Indikatorfarbstoff und bei dem zweiten Indikatorfarbstoff auftretenden Farbveränderungen können beliebig sein; insbesondere ist es möglich, die Farben der Farbstoffe vor der Bestrahlung mit aktinischer Strahlung sowie nach der Bestrahlung beliebig in geeigneter Weise zu wählen, so dass die Farbveränderungen der beiden Indikatorsysteme unabhängig voneinander nachweisbar und zudem auf dem jeweiligen entsprechenden Untergrund gut erkennbar sind. Insbesondere können der erste Indikatorfarbstoff und/oder der zweite Indikatorfarbstoff vor Einwirkung der elektromagnetischen Strahlung als Leukofarbstoff vorliegen. Als Leukofarbstoff (Leukoverbindung) wird jede Verbindung bezeichnet, die die Vorstufe einer Substanz darstellt, die Licht aus dem sichtbaren Bereich des Lichts absorbiert (eines Farbstoffs), wobei die Vorstufe selber farblos ist und somit im sichtbaren Bereich des Lichts keine oder allenfalls eine geringe Absorption aufweist. Üblicherweise ist ein Leukofarbstoff über eine Redoxreaktion in den entsprechenden gefärbten Farbstoff überführbar und liegt häufig als (zumeist reduzierte) Leukobase dieses Farbstoffs vor.

Der Mehrbereichsindikator kann hinsichtlich seiner stofflichen Konsistenz beliebig ausgebildet sein. So kann er beispielsweise als flüssige Lösung der Indikatorsysteme oder aber in Form eines Feststoffs vorliegen, etwa als pulverförmiger Indikator.

Vorteilhafterweise liegt der Mehrbereichsindikator als Bestandteil eines verfestigbaren Lackes (der zum Beispiel zusätzlich zu dem Mehrbereichsindikator ein flüssiges oder festes Bindemittel enthält sowie gegebenenfalls weitere Zusatzstoffe) oder einer Schicht (zum Beispiel eines freitragenden Films, einer Beschichtung oder dergleichen). Üblicherweise werden die Indikatorsysteme zur Anwendung in ein festes oder halbfestes Matrixmaterial eingebettet, wobei dieses Matrixmaterial beliebig gewählt werden kann, solange es selber im Bereich der Nachweiswellenlängen und der Anzeigewellenlängen keine Absorption besitzt (oder zumindest eine definierte Absorption), die Farbänderungsreaktion nicht verfälscht (also beispielsweise nicht mit der freigesetzten Lewissäure oder -base in Wechselwirkung tritt) und zudem vorzugsweise selbst nicht photochemisch reaktiv ist, um die Farbumschlagsprozesse insgesamt nicht zu stören.

Dabei ist es zudem möglich, das Matrixmaterial derart zu wählen, dass die latente Lewissäure bzw. -base und/oder die Indikatorfarbstoffe innerhalb der Matrix nur um ein Weniges beweglich sind, etwa durch die Wahl von sterisch anspruchsvollen photolatenten Lewissäuren/-basen, Indikatorfarbstoffen und/oder Matrixpolymeren oder durch photolatente Lewissäuren/-basen und/oder Indikatorfarbstoffe, die mit der Matrix über chemische Bindungen verbunden sind. Auf diese Weise werden immobilisierte Indikatorsysteme erhalten, in denen eine Änderung einer (gegebenenfalls beweglichen) freigesetzten Lewissäure bzw. -base ortsaufgelöst lokal erfasst wird und somit eine störende Wechselwirkung mit anderen Indikatorsystemen weiter verringert werden kann.

In diesem Mehrbereichsindikator können die Indikatorsysteme in beliebigen geeigneten Stoffmengen vorliegen, die einen Nachweis der jeweiligen aktinischen Strahlungsdosis gestatten. Insbesondere kann dabei das erste Indikatorsystem und/oder dass zweite Indikatorsystem in dem Mehrbereichsindikator zu einem Anteil von mindestens 0,01 Gew.-% und höchstens 10 Gew.-% vorliegen.

Der Mehrbereichsindikator kann in allen geeigneten Anwendungsformen zum Einsatz kommen, etwa als Dosismessungsflächenelement für die Messung von UV-Strahlung und/oder Elektronenstrahlen. Als Dosismessungsflächenelement wird jedes übliche und geeignete Gebilde mit im Wesentlichen flächenförmiger Ausdehnung verstanden, das zum qualitativen und/oder quantitativen Bestimmen der Dosis von auf das Flächenelement einfallender Strahlung in der Lage ist. Derartige Flächenelemente können verschieden ausgestaltet sein, insbesondere flexibel, als Folie, Band, Etikett, Filmstreifen oder als Formstanzling. Vorteilhafterweise weist ein solches Flächenelement zusätzlich zu dem Mehrbereichsindikator an einer seiner Seitenflächen eine Klebeschichtung auf, die aus einer Selbstklebemasse gebildet wird, also aus einer Haftklebemasse oder einer Hitzeaktiviert verklebenden Klebemasse, wodurch ein einfaches Verkleben des Flächenelements möglich ist, beispielsweise an der Oberfläche des zu bestrahlenden Guts, an einem Probenkörper sowie im Innern oder außerhalb einer Bestrahlungsapparatur.

Zusätzlich zu der Klebeschichtung kann das Dosismessungsflächenelement ein Trägerelement aufweisen. Als Trägerelement wird jegliches zumeist im Wesentlichen flächenförmiges Strukturelement bezeichnet, dem innerhalb des Dosismessungsflächenelements die Funktion eines permanenten Trägers zukommt. Als Trägerelement können alle geeigneten Trägermaterialien verwendet werden, etwa Folien aus Metall und/oder Kunststoffen, textile Flächenelemente (beispielsweise Gewebe, Gelege, Gewirke, Vliese) oder Kombinationen aus solchen Materialien, wobei ein Trägerelement vollflächig geschlossen oder durchbrochen ausgebildet sein kann. Stattdessen kann das Dosismessungsflächenelement aber auch trägerfrei ausgebildet sein. Grundsätzlich kann ein Flächenelement zur Dosismessung also einen beliebigen geeigneten inneren Aufbau besitzen.

Des Weiteren kann ein Flächenelement auch zusätzlich eine Bedeckungsschicht (Bedeckungselement) umfassen, die zur definierten Abschwächung der eingestrahlten UV-Strahlung und/oder Elektronenstrahlen angepasst ist. Als Bedeckungsschicht wird vorliegend jede die Oberseite des Flächenelements zumindest teilweise bedeckende flächig ausgebreitete Schichtung verstanden. Diese ist zur definierten Abschwächung der eingestrahlten UV-Strahlung und/oder Elektronenstrahlen angepasst. Eine derartige Anpassung kann etwa darin bestehen, dass das Material dieser Schichtung (etwa der Polymermatrix oder eines in der Schichtung vorhandenen Zusatzstoffs) derart gewählt wird, dass es in zumindest einem der Wellenlängenbereiche der aktinischen Strahlung selber die Strahlung absorbiert.

Dadurch, dass diese Bedeckungsschicht in Einfallsrichtung der aktinischen Strahlung (im optischen Weg) vor den Indikatorsystemen angeordnet ist, gelangt nur ein definierter Teil der eingestrahlten aktinischen Strahlung zu den Indikatorsystemen (Filterwirkung bei Abschwächung der Strahlung) und ruft dort eine Farbänderung hervor. Daher ist es durch die Auswahl von Bedeckungsschichten mit geeigneter optischer Dichte (Absorption) bei den jeweiligen Detektionswellenlängen möglich, den verfügbaren Messbereich gezielt an die konkret zu erwartenden Strahlungsdosis anzupassen. Darüber hinaus kann das Material der Bedeckungsschicht derart gewählt werden, dass eine Diffusion von gasförmigen Bestandteilen in der Umgebung des Flächenelements zu den Indikatorsystemen hin oder von den Indikatorsystemen weg verringert oder sogar unterbunden wird (etwa bei Verwendung einer sauerstoffdichten Deckfolie als Bedeckungsschicht). Da ein Einsatz einer Bedeckungsschicht insbesondere im Hinblick auf das zweite Indikatorsystem Vorteile bietet, kann als Bedeckungsschicht etwa eine Schicht eingesetzt werden, die selber eine Absorption im UVB-Bereich und/oder UVC-Bereich des Spektrums aufweist. Im Zusammenhang mit dem Einsatz einer Bedeckungsschicht wird auf den in DE 10 2004 022 071 A1 dargestellten Stand der Technik verwiesen.

Unter der erfindungsgemäßen Verwendung des Mehrbereichsindikators lässt sich die auf einen Probenkörper eingestrahlte Dosis elektromagnetischer Strahlung beispielsweise wie folgt bestimmen: Zuerst wird zumindest ein Teil der Oberfläche des Probenkörpers mit einem Mehrbereichsindikator versehen. Wird der Mehrbereichsindikator als Dosismessungslack verwendet, so wird der Dosismessungslack dazu auf den Probenkörper aufgetragen. Bei Verwendung eines Dosismessungsflächenelements, das den Mehrbereichsindikator enthält, kann das Dosismessungsflächenelement hingegen an einem Teilbereich der Oberfläche des Probenkörpers angebracht werden, etwa mittels einer Verklebung. Hierbei kann darauf zu achten sein, dass der Teilbereich des Probenkörpers, der im Rahmen des zu überwachenden Bestrahlungsverfahrens der aktinischen Strahlung ausgesetzt werden soll, nicht von dem Dosismessungsflächenelement oder dem Dosismessungslack bedeckt ist.

Anschließend wird der Probenkörper elektromagnetischer Strahlung mit Wellenlängen aus dem ersten Strahlungswellenlängenbereich und aus dem zweiten Strahlungswellenlängenbereich ausgesetzt. Infolge dieser Strahlungsexposition kommt es innerhalb des Mehrbereichsindikators im sichtbaren Bereich des Lichtspektrums zu einer Änderung der Absorption des ersten Indikatorfarbstoffs und auch einer Änderung der Absorption des zweiten Indikatorfarbstoffs, wobei der Grad der Verfärbung von der eingestrahlten Dosis in den bestimmten Spektralbereichen abhängt (und somit von der Bestrahlungsdauer und der Bestrahlungsintensität, also der Energiedichte).

Die jeweilige Absorptionsänderung des ersten Indikatorfarbstoffs und die des zweiten Indikatorfarbstoffs werden zur Dosisbestimmung erfasst. Grundsätzlich kann die Erfassung visuell (bei einer quantitativen Bestimmung etwa unter Verwendung von Farbwert-Vergleichstafeln) oder apparativ erfolgen, letzteres etwa spektral aufgelöst mit einem Spektrometer (Spektrophotometer, Photometer) oder in einem Aufbau aus einer Lichtquelle von zeitlich konstanter Intensität, einem Lichtdetektor sowie gegebenenfalls optischen Filtern. Die Messungen können dabei in Transmissionsanordnung oder in Reflexionsanordnung erfolgen. Insgesamt kann eine Erfassung insgesamt als kontinuierliche Überwachung der Strahlungsdosis durchgeführt werden oder aber zu vorher festgelegten Messzeitpunkten stichprobenartig erfolgen.

Eine Bestimmung wird vorteilhafterweise bei zwei Anzeigewellenlängen durchgeführt, nämlich bei je einer Beobachtungswellenlänge aus jedem der Wellenlängenbereiche. Wenn die Absorption des ersten Indikatorfarbstoffs und die des zweiten Indikatorfarbstoffs sich spektral überlagern, ist eine lediglich visuelle Auswertung in der Regel unvorteilhaft, da die quantitative Bestimmung hierbei nicht mehr möglich ist. Daher ist in diesem Fall einer apparativen Bestimmung und Auswertung der Absorption der Vorzug zu geben, insbesondere wenn hierbei eine rechnergestützte Parameteranpassung an die Absorptions- oder Transmissionsspektren zum Einsatz gelangt.

Die so erhaltenen Absorptionswerte oder Transmissionswerte lassen sich in die jeweils eingestrahlte Strahlungsdosis umrechnen, wobei dies unter Berücksichtigung der Stöchiometrie der photochemischen Reaktion und der Farbumschlagsreaktion und unter Berücksichtigung etwaiger Strahlungsverluste (beispielsweise infolge diffuser Streuung, Reflexion oder optischer Filter wie etwa einer Bedeckungsschicht) erfolgen kann. Letztere Korrekturen lassen sich beispielsweise auch mittels Verwendung von Kalibrierungswerten verwirklichen. Auf diese Weise ist es möglich, die Dosis der eingestrahlten elektromagnetischen Strahlung mit Wellenlängen aus dem ersten Strahlungswellenlängenbereich aus der Änderung der Lichtabsorption des ersten Indikatorfarbstoffs zu bestimmen und parallel dazu die Dosis der eingestrahlten elektromagnetischen Strahlung mit Wellenlängen aus dem zweiten Strahlungswellenlängenbereich aus der Änderung der Lichtabsorption des zweiten Indikatorfarbstoffs zu bestimmen, wobei beide Dosen unabhängig voneinander ermittelt werden.

Weitere Vorteile und Anwendungsmöglichkeiten gehen aus dem folgenden Ausführungsbeispiel hervor, das ausschließlich exemplarisch zur Verdeutlichung der erfinderischen Idee ausgewählt wurde, ohne durch die spezielle Auswahl dieses Beispiels den Schutzumfang begrenzen zu wollen.

Zur Herstellung eines Dosismessungsflächenelements wurde zunächst eine ethanolische Mehrbereichsindikatorlösung hergestellt. Diese enthielt als Matrixpolymer 97 Gew.-% Polyvinylbutyral (Pioloform von Wacker Chemie), als säureempfindlichen Farbstoff des ersten Indikatorsystems 1 Gew.-% einer Diaminofluoranverbindung (PERGASCRIPT green von Ciba Specialty Chemicals), als photolatente Säure des ersten Indikatorsystems 1 Gew.-% 1,1,3-Tris(2-methyl-4-hydroxy-5-t-butylphenyl)butan (Lowinox CA22 von Great Lakes Corp.) sowie als Indikatorfarbstoff des zweiten Indikatorsystems 1 Gew.-% Pararosanilinnitril.

Die Lösung wurde mittels eines Drahtrakels auf einer Polyesterfolie als permanenten Träger ausgestrichen und getrocknet. Die Schichtdicke der getrockneten Schicht auf dem Polyesterfilm betrug 20 µm.

Das so erhaltene Dosismessungsflächenelement wurde in einer Laborbestrahlungsanlage (Firma Eltosch) der Strahlung einer Quecksilber-Mitteldrucklampe (180 W/cm) ausgesetzt, wozu das Dosismessungsflächenelement mit einer konstanten Bahngeschwindigkeit an der Strahlungsquelle vorbeigeführt wurde. Um unterschiedliche Strahlungsdosen zu realisieren, wurde hierbei die Lampenleistung und die Bahngeschwindigkeit variiert. In der Praxis werden derartige Systeme üblicherweise zusammen mit einer Filterfolie als Bedeckungsschicht verwendet. Da bei der Demonstration des erfindungsgemäßen Prinzips das Ausführungsbeispiel so einfach wie möglich gehalten werden sollte, wurde hier eine Lampenstrahlung von lediglich geringer Intensität eingesetzt, um so auf zusätzliche Filterfolien verzichten zu können.

Zur Kalibrierung des so erhaltenen Dosismessungsflächenelements wurde die bei der jeweiligen Strahlungsdosis auftretende Änderung der optischen Transmission des belichteten Dosismessungsflächenelements für das erste Indikatorsystem bei einer Beobachtungswellenlänge von 520 nm (Farbumschlag des Fluorans) und für das zweite Indikatorsystem bei einer Beobachtungswellenlänge von 620 nm (Farbumschlag des Pararosanilinnitrils) bestimmt. Parallel dazu wurde die absolute Dosis der UV-Strahlung am Ort der Probe mit einem elektronischen Messgerät ("Power-Puck" der Firma EIT) gemessen. Mit diesem Messgerät war eine Unterteilung in drei unterschiedliche Messbereiche möglich (UVC: 250 - 260 nm; UVB: 280 - 320 nm; UVA: 320 - 390 nm).

Zur Überprüfung der Messwerte wurde die Korrelation zwischen der jeweils gemessenen Transmissionsänderung und der mit Hilfe des elektronischen Messgerätes bestimmten tatsächlichen Strahlungsdosis ermittelt. Hierzu wurden für jeweils einen Wellenlängenbereich die beiden Datensätze einer multiplen linearen Regression unter Verwendung eines quadratischen Modellansatzes der Form A = x₀ + x₁ B + x₂ B² unterzogen, wobei A die mit dem elektronischen Messgerät gemessene Strahlungsdosis, B die optische Transmission bei der jeweils gemessenen Wellenlänge (520 nm oder 620 nm) und x₀, x₁ sowie x₂ die anpassbaren Modellparameter darstellen.

Im Rahmen dieser Untersuchungen stellte sich heraus, dass die bei einer Anzeigewellenlänge von 520 nm gemessene Transmission mit der im UVA-Bereich eingestrahlten Dosis mit einem Bestimmtheitsmaß von 0,92 korreliert, wohingegen die bei einer Anzeigewellenlänge von 620 nm gemessene Transmission mit der Summe der im UVB-Bereich und UVC-Bereich eingestrahlten Dosis mit einem Bestimmtheitsmaß von 0,90 korreliert. Anhand dieses Ergebnisses ist ersichtlich, dass bei Verwendung des exemplarisch ausgewählten Beispiels des Dosismessungsflächenelements eine entsprechend den unterschiedlichen Wellenlängenbereichen differenzierte und somit wellenlängenbereichsspezifische Dosisinformation bestimmt werden kann.

Ferner wurde festgestellt, dass die so aus der Transmissionsänderung berechnete Dosisinformation eine allenfalls geringe Abhängigkeit der von der jeweiligen Lampenleistung und der gewählten Durchlaufgeschwindigkeit aufwies und daher so gut wie gar nicht von der eingestrahlten Strahlungsdosis pro Zeit abhängig ist, so dass nichtlineare Prozesse hier vernachlässigt werden können.

Zur Bestimmung der Stabilität der bestrahlten Dosismessungsflächenelemente wurden diese unter definierten klimatischen Bedingungen bei einer Temperatur von 23 °C und einer relativen Luftfeuchtigkeit von 50 % für 24 Stunden aufbewahrt und die Transmission bei den beiden Anzeigewellenlängen registriert. Hierbei wurde keine Farbänderung beobachtet.

## Patentansprüche

1. Verwendung eines Mehrbereichsindikators für eine gleichzeitige Dosisbestimmung in mindestens zwei unterschiedlichen Strahlungswellenlängenbereichen, wobei ein erster Strahlungswellenlängenbereich den UVA-Bereich des Spektrums und ein zweiter Strahlungswellenlängenbereich den UVB- und/oder den UVC-Bereich des Spektrums umfasst, mit einem ersten Indikatorsystem, das einen ersten Indikatorfarbstoff und eine photolatente Lewissäure oder photolatente Lewisbase umfasst und das bei Einwirkung von elektromagnetischer Strahlung mit Wellenlängen aus dem ersten Strahlungswellenlängenbereich auf die photolatente Lewissäure bzw. photolatente Lewisbase zu einer Freisetzung einer Lewissäure bzw. Lewisbase und zu einer Änderung der Lichtabsorption des ersten Indikatorfarbstoffs bei einer ersten Reaktion des ersten Indikatorfarbstoffs mit der freigesetzten Lewissäure bzw, Lewisbase in der Lage ist,
wobei der Mehrbereichsindikator zusätzlich zu dem ersten Indikatorsystem ein zweites Indikatorsystem aufweist, das einen zweiten Indikatorfarbstoff umfasst und das zu einer Änderung der Lichtabsorption des zweiten Indikatorfarbstoffs in einer zweiten Reaktion bei Einwirkung von elektromagnetischer Strahlung mit Wellenlängen aus dem zweiten Strahlungswellenlängenbereich in der Lage ist, wobei
der zweite Indikatorfarbstoff ein Triphenylmethanfarbstoff ist, in dem das zentrale C-Atom der Methangruppe mit einer Struktureinheit ausgewählt aus der Gruppe umfassend Halogene, Pseudohalogene, Chalkogene, Sulfate und substituierte oder unsubstituierte Tosylate verbunden ist, und in dem
zumindest einer der C₆-Ringe der Phenylgruppen in ortho- oder para-Stellung zu der Bindung zu dem zentralen Methyl-C-Atom einen elektronenziehenden Substituenten mit einem +M-Effekt und/oder in meta-Stellung zu der Bindung zu dem zentralen Methyl-C-Atom einen elektronenschiebenden Substituenten mit einem +M-Effekt aufweist.

2. Verwendung eines Mehrbereichsindikators nach Anspruch 1, **dadurch gekennzeichnet, dass** der erste Indikatorfarbstoff und/oder der zweite Indikatorfarbstoff vor Einwirkung der elektromagnetischen Strahlung als Leukofarbstoff vorliegt.

3. Verwendung eines Mehrbereichsindikators nach Anspruch oder 2, **dadurch gekennzeichnet, dass** die photolatente Lewissäure des ersten Indikatorsystems zumindest eine photolatente Bronstedsäure umfasst und der erste Indikatorfarbstoff des ersten Indikatorsystems zumindest einen Brønstedsäureempfindlichen Farbstoff umfasst.

4. Verwendung eines Mehrbereichsindikators nach Anspruch 3, **dadurch gekennzeichnet, dass** der säureempfindliche Farbstoff gewählt ist aus der Gruppe der Fluorane.

5. Verwendung eines Mehrbereichsindikators nach einem der Ansprüche 1 bis 4, **dadurch gekennzeichnet, dass** die mit dem zentralen C-Atom der Methangruppe des Triphenylmethanfarbstoffs verbundene Struktureinheit eine Cyanogruppe ist.

6. Verwendung eines Mehrbereichsindikators nach Anspruch 5, **dadurch gekennzeichnet, dass** der Triphenylmethanfarbstoff Pararosanilinnitril ist.

7. Verwendung eines Mehrbereichsindikators nach einem der Ansprüche 1 bis 6, **dadurch gekennzeichnet, dass** das erste Indikatorsystem und/oder dass zweite Indikatorsystem zu einem Anteil von mindestens 0,01 Gew.-% und höchstens 10 Gew.-% vorliegen.

8. Verfahren zum Bestimmen der auf einen Probenkörper eingestrahlten Dosis elektromagnetischer Strahlung, umfassend die folgenden Schritte:
zumindest ein Teil der Oberfläche des Probenkörpers wird mit einem Mehrbereichsindikator nach einem der Ansprüche 1 bis 7, versehen,
der Probenkörper wird elektromagnetischer Strahlung mit Wellenlängen aus dem ersten Strahlungswellenlängenbereich und aus dem zweiten Strahlungswellenlängenbereich ausgesetzt,
die Änderung der Lichtabsorption des ersten Indikatorfarbstoffs und die Änderung der Lichtabsorption des zweiten Indikatorfarbstoffs werden im sichtbaren Bereich des Lichtspektrums erfasst, und
unter Verwendung von Kalibrierungswerten werden die Dosis der eingestrahlten elektromagnetischen Strahlung mit Wellenlängen aus dem ersten Strahlungswellenlängenbereich aus der Änderung der Lichtabsorption des ersten Indikatorfarbstoffs und die Dosis der eingestrahlten elektromagnetischen Strahlung mit Wellenlängen aus dem zweiten Strahlungswellenlängenbereich aus der Änderung der Lichtabsorption des zweiten Indikatorfarbstoffs unabhängig voneinander ermittelt.

## Claims

1. Use of a multirange indicator for simultaneous dose determination in at least two different radiation wavelength ranges, where a first radiation wavelength range comprises the UVA region of the spectrum and a second radiation wavelength range comprises the UVB and/or UVC region of the spectrum, with a first indicator system, which encompasses a first indicator dye and encompasses a photolatent Lewis acid or photolatent Lewis base, and which, on exposure of the photolatent Lewis acid or, respectively, photolatent Lewis base to electromagnetic radiation with wavelengths from a first radiation wavelength range, is capable of liberating a Lewis acid or, respectively, Lewis base and of changing the light absorption of the first indicator dye during a first reaction of the first indicator dye with the liberated Lewis acid or, respectively, Lewis base,
where the multirange indicator has, in addition to the first indicator system, a second indicator system, which encompasses a second indicator dye, and which is capable of changing the light absorption of the second indicator dye in a second reaction on exposure to electromagnetic radiation with wavelengths from the second radiation wavelength range, where
the second indicator dye is a triphenylmethane dye, in which the central carbon atom of the methane group has bonding to a structural unit selected from the group consisting of halogens, pseudohalogens, chalcogens, sulphates and substituted or unsubstituted tosylates, and in which
at least one of the C₆ rings of the phenyl groups has, in ortho- or para-position with respect to the bond to the central methyl carbon atom, an electron-withdrawing substituent with +M effect, and/or has, in meta-position with respect to the bond to the central methyl carbon atom, an electron-donating substituent with +M effect.

2. Use of a multirange indicator according to Claim 1, **characterized in that** the first indicator dye and/or the second indicator dye takes the form of leuco dye prior to exposure to the electromagnetic radiation.

3. Use of a multirange indicator according to Claim 1 or 2, **characterized in that** the photolatent Lewis acid of the first indicator system encompasses at least one photolatent Brønsted acid, and the first indicator dye of the first indicator system encompasses at least one Brønsted-acid-sensitive dye.

4. Use of a multirange indicator according to Claim 3, **characterized in that** the acid-sensitive dye has been selected from the group of the fluorans.

5. Use of a multirange indicator according to any of Claims 1 to 4, **characterized in that** the structural unit bonded to the central carbon atom of the methane group of the triphenylmethane dye is a cyano group.

6. Use of a multirange indicator according to Claim 5, **characterized in that** the triphenylmethane dye is pararosaniline nitrile.

7. Use of a multirange indicator according to any of Claims 1 to 6, **characterized in that** the amount present of the first indicator system and/or of the second indicator system is at least 0.01% by weight and at most 10% by weight.

8. Method for the determination of the dose of electromagnetic radiation incident on a test specimen, encompassing the following steps:
at least one portion of the surface of the test specimen is provided with a multirange indicator according to any of Claims 1 to 7,
the test specimen is exposed to electromagnetic radiation with wavelengths from the first radiation wavelength range and from the second radiation wavelength range,
the change in the light absorption of the first indicator dye and the change in the light absorption of the second indicator dye are recorded in the visible-light region of the spectrum, and
independently of one another, and using calibration values, the dose of the incident electromagnetic radiation with wavelengths from the first radiation wavelength range is determined from the change in the light absorption of the first indicator dye, and the dose of the incident electromagnetic radiation with wavelengths from the second radiation wavelength range is determined from the change in the light absorption of the second indicator dye.

## Revendications

1. Utilisation d'un indicateur à plusieurs gammes de mesure pour une détermination simultanée de dose dans au moins deux gammes différentes de longueurs d'onde de rayonnement, une première gamme de longueurs d'onde de rayonnement comprenant la région UVA du spectre et une deuxième gamme de longueurs d'onde de rayonnement comprenant la région UVB et/ou la région UVC du spectre, à l'aide d'un premier système indicateur qui comprend un premier colorant indicateur et un acide de Lewis photolatent ou une base de Lewis photolatente et qui est capable sous l'effet d'un rayonnement électromagnétique de longueurs d'onde dans la première gamme de longueurs d'onde de rayonnement sur l'acide de Lewis photolatent ou la base de Lewis photolatente de conduire à une libération d'un acide de Lewis ou d'une base de Lewis et à une modification de la photoabsorption du premier colorant indicateur lors d'une première réaction du premier colorant indicateur avec l'acide de Lewis libéré ou la base de Lewis libérée,
l'indicateur à plusieurs gammes de mesure comportant en plus du premier système indicateur un deuxième système indicateur qui comprend un deuxième colorant indicateur et qui est capable de conduire à une modification de la photoabsorption du deuxième colorant indicateur dans une deuxième réaction sous l'effet du rayonnement électromagnétique de longueurs d'onde dans la deuxième gamme de longueurs d'onde de rayonnement,
le deuxième colorant indicateur étant un colorant triphénylméthane dans lequel l'atome de carbone central du groupe méthane est lié à une unité structurale choisie dans le groupe comprenant des halogènes, des pseudohalogènes, des chalcogènes, des sulfates et des tosylates substitués ou non substitués, et dans lequel
au moins l'un des cycles en C₆ des groupes phényle comporte en position ortho ou para par rapport à la liaison à l'atome de carbone du groupe méthyle central un substituant attirant les électrons avec un effet +M et/ou en position méta par rapport à la liaison à l'atome de carbone du groupe méthyle central un substituant donneur d'électrons avec un effet +M.

2. Utilisation d'un indicateur à plusieurs gammes de mesure selon la revendication 1, **caractérisé en ce qu'**avant l'action du rayonnement électromagnétique le premier colorant indicateur et/ou le deuxième colorant indicateur se trouve sous forme de leuco-colorant.

3. Utilisation d'un indicateur à plusieurs gammes de mesure selon la revendication 1 ou 2, **caractérisé en ce que** l'acide de Lewis photolatent du premier système indicateur comprend au moins un acide de Brønsnsted photolatent et le premier colorant indicateur du premier système indicateur comprend au moins un colorant sensible aux acides de Brønsnsted.

4. Utilisation d'un indicateur à plusieurs gammes de mesure selon la revendication 3, **caractérisé en ce que** le colorant sensible aux acides est choisi dans le groupe des fluoranes.

5. Utilisation d'un indicateur à plusieurs gammes de mesure selon l'une quelconque des revendications 1 à 4, **caractérisé en ce que** l'unité structurale liée à l'atome de carbone central du groupe méthane du colorant triphénylméthane est un groupe cyano.

6. Utilisation d'un indicateur à plusieurs gammes de mesure selon la revendication 5 **caractérisé en ce que** le colorant triphénylméthane est le pararosaniline-nitrile.

7. Utilisation d'un indicateur à plusieurs gammes de mesure selon l'une quelconque des revendications 1 à 6, **caractérisé en ce que** le premier système indicateur et/ou le deuxième système indicateur sont présents en une proportion d'au moins 0,01 % en poids et d'au maximum 10 % en poids.

8. Procédé pour la détermination de la dose de rayonnement électromagnétique reçue sur une éprouvette, comprenant les étapes suivantes :
on munit au moins une partie de la surface de l'éprouvette d'un indicateur à plusieurs gammes de mesure selon l'une quelconque des revendications 1 à 7,
on expose l'éprouvette à un rayonnement électromagnétique de longueurs d'onde dans la première gamme de longueurs d'onde de rayonnement et dans la deuxième gamme de longueurs d'onde de rayonnement,
on détermine la variation de la photoabsorption du premier colorant indicateur et la variation de la photoabsorption du deuxième colorant indicateur dans la région visible du spectre lumineux, et
en utilisant des valeurs d'étalonnage on détermine la dose du rayonnement électromagnétique incident de longueurs d'onde dans la première gamme de longueurs d'onde de rayonnement à partir de la variation de la photoabsorption du premier colorant indicateur et la dose du rayonnement électromagnétique incident de longueurs d'onde dans la deuxième gamme de longueurs d'onde de rayonnement à partie de la variation de la photoabsorption du deuxième colorant indicateur, indépendamment l'une de l'autre.
